(19) **Europäisches Patentamt / European Patent Office / Office européen des brevets**

(11) **EP 4 129 921 A1**

(12) # EUROPEAN PATENT APPLICATION
published in accordance with Art. 153(4) EPC

(43) Date of publication:
**08.02.2023 Bulletin 2023/06**

(21) Application number: **21775907.5**

(22) Date of filing: **24.03.2021**

(51) International Patent Classification (IPC):
*C01G 25/02* (1968.09)     *H01L 23/29* (1990.01)
*H01L 23/31* (1990.01)     *C08K 9/06* (1974.07)
*C08L 101/00* (1974.07)     *H01L 33/56* (2010.01)

(52) Cooperative Patent Classification (CPC):
**C01G 25/02; C08K 9/06; C08L 101/00;
H01L 23/29; H01L 23/31; H01L 33/56**

(86) International application number:
**PCT/JP2021/012271**

(87) International publication number:
**WO 2021/193727 (30.09.2021 Gazette 2021/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.03.2020 JP 2020056492**

(71) Applicant: **Sumitomo Osaka Cement Co., Ltd.
Tokyo 102-8465 (JP)**

(72) Inventors:
• ITO, Tomomi
  **Tokyo 102-8465 (JP)**
• HARADA, Kenji
  **Tokyo 102-8465 (JP)**
• OTSUKA, Takeshi
  **Tokyo 102-8465 (JP)**

(74) Representative: **Becker, Eberhard
Becker Kurig & Partner
Patentanwälte mbB
Bavariastraße 7
80336 München (DE)**

(54) **DISPERSION LIQUID, COMPOSITION, SEALING MEMBER, LIGHT EMITTING DEVICE, LIGHTING TOOL, DISPLAY DEVICE, AND METHOD FOR PRODUCING DISPERSION LIQUID**

(57)    A dispersion liquid according to the present invention contains a metal oxide particle surface-modified with a silane compound and a silicone compound, when a transmission spectrum of the metal oxide particles that are obtained by vacuum-drying the dispersion liquid is measured in a wavenumber range of 800 cm$^{-1}$ or more and 3800 cm$^{-1}$ or less with FT-IR, IA/IB ≤ 3.5 is satisfied (IA is a spectrum value at 3,500 cm$^{-1}$ and IB is a spectrum value at 1,100 cm$^{-1}$), and, when the dispersion liquid and methyl phenyl silicone are mixed such that a mass ratio of a total mass of the metal oxide particles and the surface-modifying material to a mass of methyl phenyl silicone becomes 30:70 and the hydrophobic solvent is removed, a viscosity is 9 Pa·s or less.

FIG. 1

EP 4 129 921 A1

**Description**

Technical Field

The present invention relates to a dispersion liquid containing a metal oxide particle which has been surface-modified by a silane compound and a silicone compound, a composition, a sealing member, a light-emitting device, an illumination tool, a display device, and a method for producing a dispersion liquid.
Priority is claimed on Japanese Patent Application No. 2020-056492, filed March 26, 2020, the content of which is incorporated herein by reference.

Background Art

As a light source having advantages such as a small size, a long service life, and low-voltage driving, light-emitting diodes (LED) are being broadly used. An LED chip in an LED package is generally sealed by a sealing material containing a resin in order to prevent the contact with a deterioration factor present in the external environment such as oxygen or moisture. Therefore, light emitted from the LED chip passes through the sealing material and is released outwards. Therefore, it becomes important to efficiently extract the light emitted from the LED chip to the outside of the LED package in order to increase the luminous flux emitted from the LED package.
As a sealing material for improving the extraction efficiency of light emitted from the LED chip, a composition for forming a light scattering complex containing metal oxide particles which have been surface-modified by a surface-modifying material having one or more functional groups selected from an alkenyl group, a H-Si group, and an alkoxy group and a matrix resin composition is known (for example, Patent Literature 1).
In this composition for forming a light scattering complex, a dispersion liquid containing metal oxide particles having small dispersed-particle diameters and a high refractive index is mixed with a silicone resin in a state where transparency is relatively maintained. Therefore, in a light scattering complex obtained by curing the composition for forming a light scattering complex, deterioration of the light-transmitting property is suppressed, and the light-scattering property improves.

Citation List

Patent Literature

[Patent Literature No. 1] Pamphlet of International Publication No. WO 2016/142992

Summary of Invention

Technical Problem

Incidentally, the present inventors and the like found that, when metal oxide particles having a high refractive index are contained in a sealing material, not only is the light-scattering property of a sealing member to be obtained improved, but the refractive index of the sealing member can also be improved. When the refractive index of the sealing member improves, the extraction efficiency of light from a generally-sealed light-emitting element improves. In the case of containing metal oxide particles in a sealing material for such a purpose, the content of the metal oxide particles is advantageously as large as possible from the viewpoint of improvement in the refractive index.
Incidentally, in recent years, there has been an increasing demand for a highly heat-resistant methyl-based silicone resin as a sealing resin that is used in sealing materials in order to extend the service lives of LEDs. Methyl-based silicone resins have a large content of a methyl group and a high degree of hydrophobicity compared with phenyl silicone resins and the like that have been generally used in the related art. Therefore, even metal oxide particles having a hydrophobilized surface like the invention described in Patent Literature 1 have had a problem in that, when mixed with a methyl-based silicone resin, the metal oxide particles agglomerate with each other and a transparent composition cannot be obtained. Such a problem becomes more significant as the content of the metal oxide particles in a sealing material increases.
The present invention has been made in order to solve the above-described problem, and an object of the present invention is to provide a dispersion liquid in which metal oxide particles are contained and agglomeration of the metal oxide particles is being suppressed when dispersed in a methyl-based silicone resin, a composition containing the same, a sealing member that is formed using the composition, a light-emitting device having this sealing member, an illumination tool and a display device each including this light-emitting device, and a method for producing a dispersion liquid.

Solution to Problem

In order to solve the above-described problem, a first aspect of the present invention provides a dispersion liquid containing a metal oxide particle which has been surface-modified by a surface-modifying material and a hydrophobic solvent,

in which the surface-modifying material contains a silane compound and a silicone compound,
when a transmission spectrum of the metal oxide particles that are obtained by drying the dispersion liquid by vacuum drying is measured in a wavenumber range of 800 $cm^{-1}$ or more and 3,800 $cm^{-1}$ or less with a Fourier transform infrared spectrophotometer, and spectrum values are standardized such that a maximum value of the spectrum in the range becomes 100 and a minimum value becomes 0, the following formula (1) is satisfied:

$$IA/IB \leq 3.5 \quad (1)$$

(in the formula, "IA" represents a spectrum value at 3,500 $cm^{-1}$ and "IB" represents a spectrum value at 1,100 $cm^{-1}$), and
when the dispersion liquid and methyl phenyl silicone are mixed such that a mass ratio of a total mass of the metal oxide particles and the surface-modifying material to a mass of methyl phenyl silicone becomes 30:70, and then the hydrophobic solvent is removed, a viscosity is 9 Pa·s or less.

In order to solve the above-described problem, a second aspect of the present invention provides a composition that is a mixture of the dispersion liquid and a resin component.
In order to solve the above-described problem, a third aspect of the present invention provides a sealing member that is a cured product of the composition.
In order to solve the above-described problem, a fourth aspect of the present invention provides a light-emitting device including the sealing member and a light-emitting element sealed with the sealing member.
In order to solve the above-described problem, a fifth aspect of the present invention provides an illumination tool including the light-emitting device.
In order to solve the above-described problem, a sixth aspect of the present invention provides a display device including the light-emitting device.
In order to solve the above-described problem, a seventh aspect of the present invention provides a method for producing a dispersion liquid having a step B of mixing a silane compound and metal oxide particles to obtain a liquid mixture,

a step C of dispersing the metal oxide particles in the liquid mixture to obtain a first dispersion liquid in which the metal oxide particles are dispersed,
a step D of adding a hydrophobic solvent to the first dispersion liquid to obtain a second dispersion liquid, and
a step E of adding a silicone compound to the second dispersion liquid to obtain a third dispersion liquid,
in which a content of the metal oxide particles in the liquid mixture of the step B is 10% by mass or more and 49% by mass or less, a total content of the silane compound and the metal oxide particles in the liquid mixture of the step B is 65% by mass or more and 98% by mass or less, and
the step D of adding the hydrophobic solvent is any step selected from a step d1 of heating the first dispersion liquid and, after heating, adding the hydrophobic solvent at a rate at which the metal oxide particles do not agglomerate, a step d2 of adding the hydrophobic solvent at a rate at which the metal oxide particles do not agglomerate, while heating the first dispersion liquid, and a step d3 of adding the hydrophobic solvent at a rate at which the metal oxide particles do not agglomerate and then heating the first dispersion liquid.

The above-described aspect of the present invention further has a step A of mixing the silane compound and water to obtain a hydrolyzed liquid containing the hydrolyzed silane compound, in which, in the step B of obtaining the liquid mixture, the liquid mixture may be obtained by mixing the hydrolyzed liquid and the metal oxide particles.

Advantageous Effects of Invention

As described above, according to the present invention, it is possible to provide a dispersion liquid in which metal oxide particles are contained and agglomeration of the metal oxide particles is being suppressed when dispersed in a methyl-based silicone resin, a composition containing the same, a sealing member that is formed using the composition, a light-emitting device having the sealing member, an illumination tool and a display device each including the light-emitting device, and a method for producing a dispersion liquid. The method for producing a dispersion liquid of the present invention is capable of providing a preferable dispersion liquid having an appropriate viscosity, particularly, a low initial viscosity.

Brief Description of Drawings

FIG. 1 is a schematic cross-sectional view showing a preferable example of a light-emitting device according to an embodiment of the present invention.
FIG. 2 is a schematic cross-sectional view showing another example of the light-emitting device according to the embodiment of the present invention.
FIG. 3 is a schematic cross-sectional view showing still another example of the light-emitting device according to the embodiment of the present invention.
FIG. 4 is a schematic cross-sectional view showing far still another example of the light-emitting device according to the embodiment of the present invention.

Description of Embodiments

Hereinafter, examples of a preferable embodiment of the present invention will be described in detail with reference to the accompanying drawings.
The present embodiment is simply a specific description for better understanding of the gist of the invention and does not limit the present invention unless particularly otherwise specified. Amounts, numbers, kinds, ratios, configurations, positions, sequences, ratios, and the like can be omitted, added, substituted, or changed without departing from the gist of the present invention.

<1. Present inventors and the like's idea>

First, prior to the detailed description of the present invention, an idea by the present inventors and the like that leads to the present invention will be described.
Generally, in the production of a sealing material (composition) that is to serve as a raw material of sealing members, metal oxide particles are modified by a surface-modifying material and dispersed in a resin such as a silicone resin. However, methyl-based silicone resins have a large content of a methyl group and a high degree of hydrophobicity compared with phenyl silicone resins and the like that have been generally used in the related art. Therefore, even when the metal oxide particles are modified with a surface-modifying material as described above, it has been difficult to uniformly disperse the metal oxide particles in methyl-based silicone resins.
Therefore, the present inventors and the like carried out intensive studies to solve the problem. As a result, it was found that a simple increase in the amount of the surface-modifying material used does not significantly improve the dispersibility of metal oxide particles in methyl-based silicone resins.
The present inventors and the like accepted this result, carried out additional studies, and paid attention to the modification state of the surface-modifying material on the surfaces of the metal oxide particles. That is, even when metal oxide particles are modified using a large amount of a surface-modifying material, in a case where only a small amount of the surface-modifying material is attached to the surfaces of the metal oxide particles, the surfaces of the metal oxide particle are not sufficiently hydrophobilized. On the other hand, even when metal oxide particles are modified using a small amount of a surface-modifying material, in a case where the proportion of the surface-modifying material attached to the surfaces of the metal oxide particles is high, and a large amount of the surface-modifying material is attached to the surfaces of the metal oxide particles, the surfaces of the metal oxide particles are sufficiently hydrophobilized.
In addition, the present inventors and the like found that, when a silane compound and a silicone compound are used as the surface-modifying material, the degree of attachment of the surface-modifying material to the metal oxide particles can be measured and observed with a Fourier transform infrared spectrophotometer (FT-IR). In addition, the present inventors and the like found that the degree of attachment of the surface-modifying material to the metal oxide particles can be measured and observed even at a viscosity when the surface-modifying material is mixed with a methyl-based silicone resin. In addition, it was also found that the silane compound and the silicone compound can be sufficiently attached to the surfaces of the metal oxide particles by an excellent method to be described below.

<2. Dispersion liquid>

A dispersion liquid according to the present embodiment will be described. The dispersion liquid according to the present embodiment contains metal oxide particles which have been surface-modified with a silane compound and a silicone compound and a hydrophobic solvent.

In the present embodiment, when a transmission spectrum of metal oxide particles that are obtained by drying the dispersion liquid by vacuum drying is measured in a wavenumber range of 800 $cm^{-1}$ or more and 3800 $cm^{-1}$ or less with a Fourier transform infrared spectrophotometer, and furthermore, spectrum values are standardized such that the maximum value of the spectrum in the range becomes 100 and the minimum value becomes 0, the dispersion liquid of the present embodiment satisfies the following formula (1).

$$IA/IB \leq 3.5 \quad (1)$$

(in the formula, "IA" represents a spectrum value at 3,500 $cm^{-1}$ and "IB" represents a spectrum value at 1,100 $cm^{-1}$)

When the dispersion liquid of the present embodiment and methyl phenyl silicone are mixed such that the mass ratio of the total mass of the metal oxide particles and the surface-modifying material to the mass of methyl phenyl silicone becomes 30:70, and the hydrophobic solvent is removed, the viscosity is 9 Pa·s or less.

Due to the above-described characteristics, agglomeration of the metal oxide particles is suppressed at the time of mixing the dispersion liquid according to the present embodiment with a methyl-based silicone resin and dispersing the metal oxide particles in the methyl-based silicone resin. As a result, a composition (resin composition) that is obtained as a mixture is less likely to become turbid and becomes relatively transparent.

In more detail, in a transmission spectrum that is measured with a Fourier transform infrared spectrophotometer, the position at a wavenumber of 1,100 $cm^{-1}$ belongs to a siloxane bond (Si-O-Si bond), and the position at a wavenumber of 3,500 $cm^{-1}$ belongs to a silanol group (Si-OH group). The silane compound and the silicone compound each have a Si-OH group capable of forming a Si-O-Si bond and a group capable of forming a Si-OH group. Therefore, comparison of a spectrum value (IA) at 3,500 $cm^{-1}$ and a spectrum value (IB) at 1,100 $cm^{-1}$ makes it possible to observe the reaction degree of the Si-OH group or the group capable of forming a Si-OH group in the silane compound and the silicone compound.

In addition, the present inventors and the like found that, in a case where the IA/IB is 3.5 or less, the silane compound and the silicone compound are sufficiently attached to the surfaces of the metal oxide particles. Due to such a characteristic, the metal oxide particles do not agglomerate and can be dispersed in the methyl-based silicone resin even when mixed with the methyl-based silicone resin. As a result, a composition that is obtained as a mixture is less likely to become turbid and becomes relatively transparent. Furthermore, since the metal oxide particles are contained, in the case of obtaining a sealing member that seals light-emitting elements using the composition, the refractive index of the sealing member improves compared with those of sealing members made of a methyl-based silicone resin alone. In a case where a composition is obtained using the dispersion liquid according to the present embodiment and a light-emitting element is sealed using the composition as described above, the brightness of light-emitting devices improves due to the high refractive index and light transmittance of the sealing member.

In contrast, in a case where the IA/IB exceeds 3.5, the silane compound and the silicone compound are not sufficiently attached to the surfaces of the metal oxide particles, and consequently, it is difficult to produce metal oxide particles having excellent dispersibility in methyl-based silicone resins. As a result, when the dispersion liquid and the methyl-based silicone resin are mixed together, the metal oxide particles agglomerate, and a composition to be obtained becomes turbid. The IA/IB is 3.5 or less as described above, but is preferably 3.0 or less, more preferably 2.5 or less, still more preferably 2.3 or less, and particularly preferably 2.0 or less.

In addition, the lower limit value of the IA/IB is 0 because IA is preferably 0. However, even when a small amount of a silanol group (Si-OH group) remains, it is possible to mix the metal oxide particles with the methyl-based silicone resin. Therefore, the lower limit value of the IA/IB may be 0, may be 0.1, may be 0.3, may be 0.5, may be 0.7, may be 1.0, may be 1.2, may be 1.5, or may be 1.8.

As a specific example, the transmission spectrum of the metal oxide particles can be measured with a Fourier transform infrared spectrophotometer (FT-IR) as described below.

First, the dispersion liquid of the present embodiment is dried by vacuum drying. The drying conditions need to be appropriately adjusted according to the amount and concentration of the dispersion liquid. For example, when the weight of the dispersion liquid having a solid content of 30% by mass is 10 g, the dispersion liquid may be dried at 100°C and 20 hPa or less for 2 hours or longer. As a vacuum dryer, VACUUM OVEN VOS-201SD manufactured by EYELA Tokyo Rikakikai Co., Ltd. or the like can be used.

Next, 0.01 g to 0.05 g of the metal oxide particles obtained by drying are used, whereby the transmission spectrum can be measured with a Fourier transform infrared spectrophotometer (for example, manufactured by JASCO Corporation, Model No.: FT/IR-670 Plus).

The dispersion liquid of the present embodiment and methyl phenyl silicone (methyl-based silicone resin) are mixed such that the mass ratio of the total mass of the metal oxide particles and the surface-modifying material (the silane compound and the silicone compound) to the mass of methyl phenyl silicone becomes 30:70 to produce a mixture. After that, when the hydrophobic solvent is removed from the mixture, the viscosity is 9 Pa·s or less.

The viscosity is 9.0 Pa·s or less, 8.5 Pa·s or less, 8.0 Pa·s or less, 7.5 Pa·s or less, 7.0 Pa·s or less, 6.5 Pa·s or less, or 6.0 Pa·s or less.

The viscosity of the methyl phenyl silicone used may be, for example, 1 to 10 Pa·s, 1 to 9 Pa·s, 2 to 5 Pa·s, or 2 to 3 Pa·s. As a specific example, methyl phenyl silicone having a viscosity (23°C) of 2.7 Pa·s or the like may be preferably used.

As the methyl phenyl silicone, for example, KER-2500-B manufactured by Shin-Etsu Chemical Co., Ltd. can be preferably used.

The lower limit value of the viscosity may be the viscosity of methyl phenyl silicone itself or may be, for example, the viscosity of KER-2500-B itself. The lower limit value of the viscosity may be, for example, 1.0 Pa·s or more, 1.5 Pa·s or more, 2.0 Pa·s or more, or 2.5 Pa·s or more, or 3.0 Pa·s or more.

It is preferable to completely remove the hydrophobic solvent from the mixture with an evaporator or the like. However, since it is difficult to completely remove the hydrophobic solvent, about 5% by mass of the hydrophobic solvent may remain. That is, the hydrophobic solvent may be contained in an amount of 0% to 5.0% by mass, 0.1% to 3.0% by mass, or 0.5% to 1.0% by mass.

The viscosity is measured using a rheometer, for example, a rheometer (trade name: RHEOSTRESS RS-6000, manufactured by HAAKE) under conditions of 25°C and a shear rate of 1 (1/S).

When the hydrophobic solvent is removed from the composition containing the hydrophobic solvent (the composition containing the metal oxide particles, the surface-modifying material, and the methyl-based silicone resin), the particles come close to each other, and the viscosity of the composition increases. That is, when the hydrophobic solvent is removed, the particles come close to each other, and the viscosity of the composition (the composition containing the metal oxide particles, the surface-modifying material, and methyl phenyl silicone) increases. As time passes, the viscosity increases.

Therefore, the viscosity when the above-described hydrophobic solvent has been removed means the viscosity of the composition measured within 1 hour after the hydrophobic solvent is removed from the dispersion liquid.

When the viscosity of the dispersion liquid is 9 Pa·s or less, an increase in the viscosity of the composition after methyl phenyl silicone and the dispersion liquid are mixed and the hydrophobic solvent is removed is slow. Therefore, the handling of the composition becomes easy, and the quality stability of the sealing member can be improved.

Until now, there has been no finding that, regarding metal oxide particles as described above, the IA/IB value can be achieved and the viscosity when mixed with methyl phenyl silicone can be made to be 9 Pa·s or less. The present inventors and the like have found that a dispersion liquid having the above-described excellent effect can be obtained for the first time by a method to be described below and an excellent effect can be achieved.

Hereinafter, each component that is contained in the dispersion liquid will be described.

(2.1 Metal oxide particles)

The metal oxide particles scatter light that is emitted from light-emitting elements in a sealing member to be described below. In addition, depending on the kind, the metal oxide particles improve the refractive index of the sealing member. This makes the metal oxide particles contribute to improvement in the brightness of light in light-emitting devices.

The metal oxide particles that are contained in the dispersion liquid according to the present embodiment are not particularly limited. In the present embodiment, as the metal oxide particles, for example, at least one or more kinds of metal oxide particles selected from the group consisting of zirconium oxide particles, titanium oxide particles, zinc oxide particles, iron oxide particles, copper oxide particles, tin oxide particles, cerium oxide particles, tantalum oxide particles, niobium oxide particles, tungsten oxide particles, europium oxide particles, yttrium oxide particles, molybdenum oxide particles, indium oxide particles, antimony oxide particles, germanium oxide particles, lead oxide particles, bismuth oxide particles, and hafnium oxide particles and potassium titanate particles, barium titanate particles, strontium titanate particles, potassium niobate particles, lithium niobate particles, calcium tungstate particles, yttria-stabilized zirconia particles, alumina-stabilized zirconia particles, calcia-stabilized zirconia particles, magnesia-stabilized zirconia particles, scandia-stabilized zirconia particles, hafnia-stabilized zirconia particles, ytterbia-stabilized zirconia particles, ceria-stabilized zirconia particles, india-stabilized zirconia particles, strontium-stabilized zirconia particles, samarium oxide-stabilized zirconia particles, gadolinium oxide-stabilized zirconia particles, antimony-added tin oxide particles, and indium-added tin oxide particles are preferably used.

Among the above-described metal oxide particles, the dispersion liquid preferably contains at least one kind selected from the group consisting of zirconium oxide particles and titanium oxide particles from the viewpoint of improving transparency or compatibility (affinity) with a sealing resin (resin component).

In addition, the metal oxide particles preferably have a refractive index of 1.7 or higher from the viewpoint of improving the refractive index of the sealing member.

The metal oxide particles are more preferably at least one of zirconium oxide particles and titanium oxide particles and particularly preferably zirconium oxide particles.

The metal oxide particles may be dispersed as primary particles in the dispersion liquid or may be dispersed as secondary particles that are agglomerates of the primary particles. Usually, the metal oxide particles are dispersed as secondary particles.

The average dispersed-particle diameter of the metal oxide particles in the dispersion liquid is not particularly limited, but is, for example, 10 nm or more and 300 nm or less, preferably 20 nm or more and 250 nm or less, and more preferably 30 nm or more and 200 nm or less. The average dispersed-particle diameter may be 30 nm or more and 80 nm or less, 30 nm or more and 100 nm or less, 80 nm or more and 180 nm or less, or the like as necessary. When the average dispersed-particle diameter of the metal oxide particles is 10 nm or more, the brightness of light of a light-emitting device to be described below that is produced using this dispersion liquid improves. In addition, when the average dispersed-particle diameter of the metal oxide particles is 300 nm or less, it is possible to suppress a decrease in the light transmittance of the dispersion liquid or a composition to be described below and the sealing member that are produced using the dispersion liquid. As a result, the brightness of light of the light-emitting device improves.

The average dispersed-particle diameter of the metal oxide particles is the particle diameter D50 of the metal oxide particles when the cumulative percentage of a scattering intensity distribution that is obtained by a dynamic light scattering method is 50%. This value can be measured with a dynamic light scattering-type particle size distribution meter (for example, manufactured by Horiba, Ltd., Model No.: SZ-100SP). The measurement can be carried out on a dispersion liquid having a solid content adjusted to 5% by mass as a subject using a silica cell having a 10 mm x 10 mm optical path length. In the present specification, "solid content" refers to a residue when a volatile component has been removed from the dispersion liquid. For example, when the dispersion liquid, for example, 1.2 g of the dispersion liquid is put into a magnetic crucible and heated at 100°C for one hour on a hot plate, a component that does not volatilize but remains (the metal oxide particles, the surface-modifying material, or the like) can be regarded as the solid content.

The average dispersed-particle diameter of the metal oxide particles is measured and calculated based on the diameters of the metal oxide particles in a dispersed state regardless of whether the metal oxide particles are dispersed in a primary particle or secondary particle state. In addition, in the present embodiment, the average dispersed-particle diameter of the metal oxide particles may be measured as the average dispersed-particle diameter of the metal oxide particles to which the surface-modifying material has been attached. In the dispersion liquid, the metal oxide particles to which the surface-modifying material has been attached and the metal oxide particles to which the surface-modifying material is not attached can be present. Therefore, usually, the average dispersed-particle diameter of the metal oxide particles is measured as a value in a mixed state thereof.

The average primary particle diameter of the metal oxide particles that are contained in the dispersion liquid and prepared as a material can be randomly selected, but is preferably 3 nm or more and 200 nm or less, more preferably 5 nm or more and 170 nm or less, and still more preferably 10 nm or more and 100 nm or less. The average primary particle diameter of the particles may be 5 to 20 nm, may be 5 to 25 nm, or may be 50 to 120 nm or 50 to 150 nm as necessary. When the average primary particle diameter of the metal oxide particles is in the above-described range, it is possible to suppress the deterioration of the transparency of the sealing member. As a result, it is possible to further improve the brightness of light of light-emitting devices.

The average primary particle diameter of the metal oxide particles can be measured by an randomly-selected method. For example, the average primary particle diameter can be measured by observation with a transmission electron microscope. First, a collodion film obtained by collecting the metal oxide particles from the dispersion liquid is observed with a transmission electron microscope, and a transmission electron microscopic image is obtained. Next, a predetermined number, for example, 100 of the metal oxide particles in the transmission electron microscopic image are selected. In addition, the longest straight-line segments (longest diameters) of the individual metal oxide particles are measured, and these measurement values are arithmetically averaged, thereby obtaining the average primary particle diameter of the metal oxide particles.

Here, in a case where the metal oxide particles agglomerate together, the measurement subject is not the agglomerated particle diameter of this agglomerate. The longest diameters of a predetermined number of particles (primary particles) of the metal oxide particles that configure this agglomerate are measured, and the average primary particle diameter is obtained.

In addition, the content of the metal oxide particles in the dispersion liquid is not particularly limited as long as the metal oxide particles can be mixed with a resin component to be described below. The content of the metal oxide particles in the dispersion liquid can be randomly selected, but is, for example, preferably 1% by mass or more and 70% by mass or less, more preferably 5% by mass or more and 50% by mass or less, still more preferably 7% by mass or more and 40% by mass or less, and particularly preferably 10% by mass or more and 30% by mass or less. The content of the metal oxide particles in the dispersion liquid may be 20% by mass or more and 40% by mass or less or 25% by mass or more and 35% by mass or less as necessary.

With such an amount of the metal oxide particles, it is possible to suppress the viscosity of the dispersion liquid becoming excessively large. Therefore, it becomes easy to mix the metal oxide particles with the resin component to be described below. In addition, it is possible to suppress the amount of a solvent (dispersion medium) becoming excessive after the mixing of the metal oxide particles with the resin component, which makes it easy to remove the solvent. The metal oxide particles in the dispersion liquid of the present embodiment may be metal oxide particles that have been first surface-modified with a silane compound and then surface-modified with a silicone compound.

To the surfaces of the metal oxide particles described above, a surface-modifying material to be described below is attached. Due to this attachment, the metal oxide particles are stably dispersed in the dispersion liquid and dispersion liquids that are produced using the dispersion liquid.

(2.2 Surface-modifying material)

The dispersion liquid according to the present embodiment contains a silane compound and a silicone compound as the surface-modifying material. As the surface-modifying material, only a silane compound and a silicone compound may be used.

At least a part of this surface-modifying material is attached to the surfaces of the metal oxide particles in the dispersion liquid to modify the surfaces, thereby preventing the agglomeration of the metal oxide particles. Furthermore, the attachment improves the compatibility with the resin component.

Here, the surface-modifying material "being attached to" the metal oxide particles refers to the fact that the surface-modifying material comes into contact with or bonds to the metal oxide particles by an interaction or reaction therebetween. As the contact, for example, physical adsorption is exemplified. In addition, as the bond, an ionic bond, a hydrogen bond, a covalent bond, and the like are exemplified.

The dispersion liquid according to the present embodiment contains at least a silane compound and a silicone compound as the surface-modifying material. That is, in the present embodiment, the metal oxide particles are surface-modified with at least a silane compound and a silicone compound.

The silane compound is likely to be attached to the vicinities of the surfaces of the metal oxide particles. On the other hand, the silicone compound has a relatively large molecular weight and contributes to improvement in the affinity mainly to dispersion medium or the resin component to be described below. The joint use of the silane compound and the silicone compound improves the dispersion stability of the metal oxide particles in the methyl-based silicone resin.

On the other hand, in a case where the dispersion liquid does not contain any one of the silane compound and the silicone compound, the above-described excellent effect cannot be obtained. For example, in a case where the dispersion liquid does not contain the silane compound, the silicone compound is less likely to be attached to the surfaces of the metal oxide particles, and the dispersibility of the metal oxide particles in the methyl-based silicone resin becomes poor. On the other hand, in a case where the dispersion liquid does not contain the silicone compound, the affinity between the metal oxide particles and the methyl-based silicone resin does not become sufficiently large, and the dispersibility of the metal oxide particles in the methyl-based silicone resin becomes poor.

(Silane compound)

The silane compound can be randomly selected, and examples thereof include silane compounds including an alkyl group and an alkoxy group such as methyltrimethoxysilane, methyltriethoxysilane, methyltripropoxysilane, ethyltrimethoxysilane, ethyltriethoxysilane, and ethyltripropoxysilane, isobutyltrimethoxysilane, methylphenyldimethoxysilane and methylphenyldiethoxysilane, silane compounds including an alkenyl group and an alkoxy group such as vinyltrimethoxysilane, methacryloxypropyltrimethoxysilane and acryloxipropyltrimethoxysilane, silane compounds including a H-Si group and an alkoxy group such as diethoxymonomethylsilane, monoethoxydimethylsilane, diphenylmonomethoxysilane and diphenylmonoethoxysilane, silane compounds including other alkoxy groups such as phenyltrimethoxysilane, silane compounds including a H-Si group such as dimethylchlorosilane, methyldichlorosilane, diethylchlorosilane, ethyldichlorosilane, methylphenylchlorosilane, diphenylchlorosilane, phenyldichlorosilane, trimethoxysilane, dimethoxysilane, monomethoxysilane and triethoxysilane, and the like. These silane compounds may be used singly or two or more silane compounds may be used in combination. Among these, the silane compounds having an alkoxy group, particularly, a methoxy group, are preferable since those compounds are easily attached to the metal oxide particles.

Among them, the silane compound preferably contains a silane compound including alkyl groups and alkoxy groups from the viewpoint of a low viscosity and easy dispersion of the metal oxide particles in a dispersion step to be described below.

The number of the alkoxy groups in such a silane compound including alkyl groups and alkoxy groups is preferably 1 or more and 3 or less, and the number of the alkoxy groups is more preferably 3. The number of the alkoxy groups may be 1 or 2 as necessary. The number of carbon atoms in the alkoxy group can be randomly selected, but is preferably 1 or more and 5 or less. The number of carbon atoms may be 1 or more and 3 or less or 2 or more and 4 or less.

The number of the alkyl groups in the silane compound including alkyl groups and alkoxy groups is preferably 1 or more and 3 or less and more preferably 1. The number of the alkyl groups may be 2 or 3 as necessary. The number of carbon atoms of the alkyl group is preferably 1 or more and 5 or less, more preferably 1 or more and 3 or less, and still more preferably 1 or more and 2 or less.

The total number of the alkoxy groups and the alkyl groups in the silane compound including alkyl groups and alkoxy groups is preferably 2 or more and 4 or less and preferably 4.

Examples of the silane compound as such a surface-modifying material include methyltrimethoxysilane, methyltriethoxysilane, methyltripropoxysilane, ethyltrimethoxysilane, ethyltriethoxysilane, and ethyltripropoxysilane, and at least one selected from the group consisting of these compounds can be preferably contained.

The content of the silane compound in the dispersion liquid can be randomly selected and is not particularly limited, but is, for example, preferably 50% by mass or more and 500% by mass or less, more preferably 70% by mass or more and 400% by mass or less, and still more preferably 90% by mass or more and 300% by mass or less with respect to 100% by mass of the amount of the metal oxide particles. The amount may be 80% by mass or more and 350% by mass or less or 150% by mass or more and 250% by mass or less as necessary. In such a case, it is possible to attach a sufficient amount of the silicone compound to the surfaces of the metal oxide particles through the silane compound and to improve the dispersion stability of the metal oxide particles and improve the dispersibility into the methyl-based silicone resin.

(Silicone compound)

The silicone compound can be randomly selected, and examples thereof include alkoxy group-containing phenyl silicone, dimethyl silicone, methyl phenyl silicone, methyl hydrogen silicone, methyl phenyl hydrogen silicone, diphenyl hydrogen silicone, alkoxy both-terminal phenyl silicone, alkoxy both-terminal methyl phenyl silicone, alkoxy group-containing methyl phenyl silicone, alkoxy group-containing dimethyl silicone, alkoxy one-terminal trimethyl one-terminal (methyl group one-terminal) dimethyl silicone, alkoxy group-containing phenyl silicone, and the like. These silicone compounds may be used singly or two or more silicone compounds may be used in combination.

The silicone compound may be a monomer, may be an oligomer, or may be a resin (polymer). A monomer or an oligomer is preferably used since surface modification is easy.

Among the above-described silicone compounds, from the viewpoint of easiness in reaction and high hydrophobicity, the silicone compound is preferably alkoxy group-containing phenyl silicone, dimethyl silicone, methyl phenyl silicone, alkoxy both-terminal phenyl silicone, alkoxy both-terminal methyl phenyl silicone, alkoxy group-containing methyl phenyl silicone, alkoxy group-containing dimethyl silicone, alkoxy one-terminal trimethyl one-terminal (methyl group one-terminal) dimethyl silicone, and alkoxy group-containing phenyl silicone. At least one selected from the group consisting of these compounds can be contained. The silicone compound more preferably contains at least one selected from the group consisting of methoxy group-containing phenyl silicone, dimethyl silicone, and methoxy group-containing dimethyl silicone.

The content of the silicone compound in the dispersion liquid can be randomly selected and is not particularly limited. The content of the silicone compound is, for example, preferably 50% by mass or more and 500% by mass or less, more preferably 80% by mass or more and 400% by mass or less, and still more preferably 100% by mass or more and 300% by mass or less with respect to, for example, 100% by mass of the amount of the metal oxide particles. The amount may be 50% by mass or more and 200% by mass or less or 50% by mass or more and 150% by mass or less as necessary. In such a case, it is possible to attach a sufficient amount of the silicone compound to the surfaces of the metal oxide particles and to improve the dispersion stability of the metal oxide particles and improve the dispersibility into the methyl-based silicone resin. Furthermore, it is possible to reduce the amount of the silicone compound isolated and to suppress unintended agglomeration of the metal oxide particles in the methyl-based silicone resin.

(Other compounds)

In addition, the dispersion liquid may contain components other than the silane compound and the silicone compound as the surface-modifying material. Examples of such components include carbon-carbon unsaturated bond-containing fatty acids, specifically, a methacrylic acid, an acrylic acid, and the like.

(Total content of silane compound and silicone compound)

The amount of the surface-modifying material, that is, the total content of the silane compound and the silicone compound with respect to the metal oxide particles is not particularly limited and can be randomly selected. The amount of the surface-modifying material is, for example, preferably 100% by mass or more and 1000% by mass or less, more preferably 150% by mass or more and 800% by mass or less, and still more preferably 190% by mass or more and 600% by mass or less with respect to the amount of the metal oxide particles. The amount may be 200% by mass or more and 900% by mass or less or 250% by mass or more and 850% by mass or less. When the amount of the surface-modifying material is in the above-described range, it is possible to sufficiently improve the dispersibility of the metal oxide particles while reducing the amount of the surface-modifying material to be isolated.

(2.3 Hydrophobic solvent)

The dispersion liquid according to the present embodiment contains a hydrophobic solvent that disperses the metal oxide particles as a dispersion medium. This hydrophobic solvent is not particularly limited as long as the hydrophobic solvent is capable of dispersing the metal oxide particles to which the surface-modifying material has been attached and can be mixed with the resin component to be described below.

Examples of such a hydrophobic solvent include aromatic solvents, saturated hydrocarbons, unsaturated hydrocarbons, and the like. These hydrophobic solvents may be used singly or two or more hydrophobic solvents may be used in combination.

Among the above-described hydrophobic solvents, aromatic solvents, particularly, aromatic hydrocarbons are preferable. The aromatic solvents have excellent compatibility with the methyl-based silicone resin to be described below and thereby contribute to improvement in the viscosity characteristics of compositions to be obtained and improvement in the qualities (transparency, shape, and the like) of sealing members to be formed.

Examples of such aromatic hydrocarbons include benzene, toluene, ethylbenzene, 1-phenylpropane, isopropylbenzene, n-butylbenzene, tert-butylbenzene, sec-butylbenzene, o-, m-, or p-xylene, 2-, 3-, or 4-ethyltoluene, and the like. These aromatic hydrocarbons may be used singly or two or more aromatic hydrocarbons may be used in combination.

Among the above-described aromatic hydrocarbons, from the viewpoint of the stability of the dispersion liquid or easiness in handleability in the removal of the hydrophobic solvent or the like during the production of a composition to be described below, at least one selected from the group consisting of toluene, o-, m-, or p-xylene, and benzene is particularly preferably used.

The content of the hydrophobic solvent contained in the dispersion liquid can be randomly selected, but needs to be appropriately adjusted so as to obtain a desired solid content. The content of the hydrophobic solvent is, for example, preferably 40% by mass or more and 95% by mass or less, more preferably 50% by mass or more and 90% by mass or less, and still more preferably 60% by mass or more and 80% by mass or less. In such a case, the mixing of the dispersion liquid and the resin component to be described below, particularly, the methyl-based silicone resin becomes easier. The amount may be 60% by mass or more and 90% by mass or less, 65% by mass or more and 85% by mass or less, or 70% by mass or more and 80% by mass or less as necessary.

(Hydrophilic solvent)

The dispersion liquid of the present embodiment may contain a hydrophilic solvent. The hydrophilic solvent can be contained in the dispersion liquid due to, for example, a method to be described below. Examples of such a hydrophilic solvent include alcohol-based solvents, ketone-based solvents, nitrile-based solvents, and the like. These hydrophilic solvents may be used singly or two or more hydrophilic solvents may be used in combination.

Examples of the alcohol-based solvents include branched or linear alcohol compounds having 1 to 4 carbon atoms and ether condensates thereof. These alcohol-based solvents may be used singly or two or more alcohol-based solvents may be used in combination. In addition, an alcohol compound that is contained in the alcohol-based solvents may be any of a primary alcohol, a secondary alcohol, and a tertiary alcohol. In addition, the alcohol compound that is contained in the alcohol-based solvents may be any of a monohydric alcohol, a dihydric alcohol, and a trihydric alcohol. More specifically, examples of the alcohol-based solvents include methanol, ethanol, 1-propanol, isopropyl alcohol, 1-butyl alcohol, 2-butanol, isobutyl alcohol, tert-butyl alcohol, methanediol, 1,2-ethanediol, 1,2-propanediol, 1,3-propanediol, 1,2-butanediol, 1,3-butanediol, 1,4-butanediol, 2,3-butanediol, 2-butene-1,4-diol, 1,4-butynediol, glycerin, diethylene glycol, 3-methoxy-1,2-propanediol, and the like.

Examples of the ketone-based solvents include acetone, methyl ethyl ketone, methyl isobutyl ketone, cyclohexanone, and the like.

Examples of the nitrile-based solvents include acetonitrile and the like.

From the viewpoint of excellent affinity to both water and the hydrophobic solvent and acceleration of the mixing thereof, the hydrophilic solvent preferably contains the alcohol-based solvent. In this case, the number of carbon atoms in the alcohol compound that configures the alcohol-based solvent is preferably 1 or more and 3 or less and more preferably 1 or more and 2 or less.

Among the above-described alcohol compounds, methanol and ethanol, particularly, methanol, can be preferably used since it is possible to sufficiently develop the effect of the above-described alcohol-based solvents.

In addition, the content of the hydrophilic solvent in the dispersion liquid is, for example, preferably 10% by mass or less, more preferably 7% by mass or less, still more preferably 5% by mass or less, and particularly preferably 3% by mass or less. The content of the hydrophilic solvent may be 0% by mass.

(2.4 Other components)

The dispersion liquid according to the present embodiment may contain components other than the components described above. For example, the dispersion liquid according to the present embodiment may contain, as necessary, components other than the components described above, for example, general additives such as a dispersant, a dispersion aid, an antioxidant, a flow adjuster, a viscosity improver, a pH adjuster, and a preservative.

In addition, the dispersion liquid according to the present embodiment may contain components that may be contained due to the method to be described below, for example, an acid, water, an alcohol, and the like.

In the present specification, the dispersion liquid according to the present embodiment is differentiated from a composition according to the present embodiment that contains a resin component and is capable of forming sealing members by curing. That is, even in a case where the dispersion liquid according to the present embodiment contains the resin component to be described below, the dispersion liquid does not contain the resin component to be described below much enough to form sealing members when simply cured. More specifically, the mass ratio of the resin component to the metal oxide particles in the dispersion liquid according to the present embodiment is preferably in a range of 0:100 to 40:60, more preferably in a range of 0:100 to 30:70, and still more preferably in a range of 0:100 to 20:80 (resin component : metal oxide particles). The dispersion liquid according to the present embodiment particularly preferably does not essentially contain the resin component to be described below and most preferably does not contain the resin component to be described below at all.

In the dispersion liquid according to the present embodiment, the surfaces of the metal oxide particles are sufficiently modified with the silane compound and the silicone compound. In addition, the metal oxide particles modified as described above have an excellent affinity to the methyl-based silicone resin and can be relatively uniformly dispersed in the methyl-based silicone resin. Therefore, even in a case where the metal oxide particles are dispersed in the methyl-based silicone resin, the occurrence of turbidity such as white turbidity is suppressed. Furthermore, a change in the viscosity of the methyl-based silicone resin containing the metal oxide particles is also suppressed.

<3. Method for producing dispersion liquid>

Next, a method for producing a dispersion liquid according to the present embodiment will be described.

The method for producing a dispersion liquid according to the present embodiment has a step B of mixing a silane compound and the metal oxide particles to obtain a liquid mixture,

a step C of dispersing the metal oxide particles in the liquid mixture to obtain a first dispersion liquid in which the metal oxide particles are dispersed,
a step D of adding a hydrophobic solvent to the first dispersion liquid to obtain a second dispersion liquid, and
a step E of adding a silicone compound to the second dispersion liquid to obtain a third dispersion liquid.

The content of the metal oxide particles in the liquid mixture of the step B is 10% by mass or more and 49% by mass or less, and the total content of the silane compound and the metal oxide particles in the liquid mixture is 65% by mass or more and 98% by mass or less.

The step D of adding the hydrophobic solvent is any of a step d1 of heating the first dispersion liquid and then adding the hydrophobic solvent at a rate at which the metal oxide particles do not agglomerate, a step d2 of adding the hydrophobic solvent at a rate at which the metal oxide particles do not agglomerate while heating the first dispersion liquid, or a step d3 of adding the hydrophobic solvent at a rate at which the metal oxide particles do not agglomerate and then heating the first dispersion liquid.

The total content of the silane compound and the metal oxide particles can also be evaluated by the solid content.

In addition, the total content of the silane compound and the metal oxide particles does not include an alcohol that is generated by the hydrolysis of the silane compound to be described below. That is, the total content of the silane compound and the metal oxide particles means the total content of the silane compound, the hydrolyzed silane compound, and the metal oxide particles. It is needless to say that the total content is a value including the content of the metal oxide particles attached to the silane compound.

In addition, in the present embodiment, prior to each of the above-described steps, a step A (hydrolysis step) of mixing a silane compound and water to obtain a hydrolyzed liquid containing a hydrolyzed silane compound may be provided.

Hereinafter, each step will be described in detail.

(Step A (hydrolysis step))

In the hydrolysis step, at least a silane compound and water are mixed to obtain a hydrolyzed liquid containing a hydrolyzed silane compound. The use of a liquid mixture in which at least a part of a silane compound is hydrolyzed in advance as described above makes it easy for the silane compound to be attached to the metal oxide particles in a dispersion step to be described below.

As the silane compound, one of the above-described silane compounds may be used singly or two or more silane compounds may be used in combination.

In addition, the content of the silane compound in the hydrolyzed liquid is not particularly limited. The content of the silane compound can be defined as the remainder remaining after other components are removed from the hydrolyzed liquid and is preferably 60% by mass or more and 99% by mass or less, more preferably 70% by mass or more and 97% by mass or less, and still more preferably 80% by mass or more and 95% by mass or less. The content of the silane compound in the hydrolyzed liquid may be 85% by mass or more and 95% by mass or less or 87% by mass or more and 93% by mass or less as necessary.

In the hydrolysis step, a surface-modifying material other than the silane compound may be contained in the hydrolyzed liquid.

In addition, in the hydrolysis step, the hydrolyzed liquid contains water. Water serves as a substrate for the hydrolysis reaction of surface-modifying materials such as the silane compound.

The content of water in the hydrolyzed liquid is not particularly limited and can be randomly selected. For example, the content of water can be appropriately set in accordance with the amount of the silane compound. For example, the amount of water that is added to the hydrolyzed liquid is preferably 0.5 mol or more and 5 mol or less, more preferably 0.6 mol or more and 3 mol or less, and still more preferably 0.7 mol or more and 2 mol or less with respect to 1 mol of the silane compound. In such a case, it is possible to more reliably prevent the occurrence of the agglomeration of the metal oxide particles in a dispersion liquid to be produced due to the excess amount of water while causing the hydrolysis reaction of the silane compound to sufficiently progress.

Alternatively, the content of water in the hydrolyzed liquid is, for example, preferably 1% by mass or more and 20% by mass or less, more preferably 1% by mass or more and 15% by mass or less, and still more preferably 1% by mass or more and 10% by mass or less.

In addition, a catalyst may be added to the hydrolyzed liquid together with the silane compound and water. As the catalyst, for example, an acid or a base can be used.

The acid catalyzes the hydrolysis reaction of the silane compound in the hydrolyzed liquid. On the other hand, the base catalyzes a condensation reaction between the hydrolyzed silane compound and functional groups on the surfaces of the metal oxide particles, for example, hydroxyl groups or silanol groups. These reactions make it easy for the silane compound, firstly, the silane compound to be attached to the metal oxide particles in the dispersion step (step C) to be described below and improve the dispersion stability of the metal oxide particles.

Here, the above-described "acid" refers to an acid based on the so-called Bronsted-Lowry definition and refers to a substance that donates a proton in the hydrolysis reaction of the surface-modifying material such as the silane compound. In addition, the above-described "base" refers to a base based on the so-called Bronsted-Lowry definition and, here, refers herein to a substance that accepts a proton in the hydrolysis reaction of the surface-modifying material such as the silane compound and the following condensation reaction.

The acid is not particularly limited as long as the acid is capable of supplying a proton in the hydrolysis reaction of the silane compound and can be randomly selected. Examples of the acid include inorganic acids such as hydrochloric acid, hydrobromic acid, hydroiodic acid, sulfuric acid, nitric acid, boric acid, and phosphoric acid and organic acids such as acetic acid, citric acid and formic acid. These acids may be used singly or two or more acids may be used in combination.

The base is not particularly limited as long as the base is capable of accepting a proton in the hydrolysis reaction of the silane compound and can be randomly selected. Examples thereof include sodium hydroxide, potassium hydroxide, barium hydroxide, calcium hydroxide, ammonia, amines, and the like. These bases may be used singly or two or more bases may be used in combination.

Among the above-described catalysts, the acid is preferably used as the catalyst. As the acid, the inorganic acid is preferable, and hydrochloric acid is more preferable from the viewpoint of the acidity.

The content of the catalyst in the hydrolyzed liquid is not particularly limited, but is preferably 10 ppm or more and 1000 ppm or less, more preferably 20 ppm or more and 800 ppm or less, and still more preferably 30 ppm or more and 600 ppm or less. In such a case, it is possible to suppress a side reaction of the silane compound while sufficiently accelerating the hydrolysis of the silane compound. The content of the catalyst in the hydrolyzed liquid may be 0.1 ppm or more and 100 ppm or less or 1 ppm or more and 10 ppm or less as necessary. In addition, for example, when an acid such as hydrochloric acid (1N) is used as the catalyst, the amount of the acid may be 0.001 parts by mass or more and 5 parts by mass or less, may be 0.001 parts by mass or more and 3 parts by mass or less, may be 0.005 parts by mass or more and 1 part by mass or less, or may be 0.005 parts by mass or more and 0.1 parts by mass or less with respect to 100 parts by mass in the hydrolyzed liquid.

In addition, the hydrolyzed liquid may contain a hydrophilic solvent as necessary. The hydrophilic solvent is capable of further accelerating the hydrolysis reaction of the silane compound by accelerating the mixing of water and the silane compound in the hydrolyzed liquid.

Examples of such a hydrophilic solvent include a variety of hydrophilic solvents that can be contained in the above-described dispersion liquid.

Among the above-described hydrophilic solvents, the hydrophilic solvent is preferably at least one selected from the group consisting of alcohol-based solvents and more preferably at least one selected from the group consisting of methanol and ethanol from the viewpoint of having excellent affinity to both water and hydrophobic solvents and accelerating the mixing thereof.

In addition, the content of the hydrophilic solvent in the hydrolyzed liquid is not particularly limited, but is, for example, preferably 60% by mass or less and more preferably 50% by mass or less. In this range, it is possible to sufficiently increase the content of the silane compound and water in the hydrolyzed liquid. The content of the hydrophilic solvent may be 40% by mass or less or 20% by mass or less. In addition, the content of the hydrophilic solvent in the hydrolyzed liquid is, for example, preferably 10% by mass or more and, more preferably 15% by mass or more. In this range, it is possible to further accelerate the mixing of the surface-modifying material and water and, consequently, to cause the hydrolysis reaction of the surface-modifying material to efficiently progress. The hydrolyzed liquid may not contain any hydrophilic solvents except for a compound derived from the hydrolysis reaction. That is, only a hydrophilic solvent that is a compound derived from the hydrolysis reaction may be contained.

In the present embodiment, in the case of using a silane compound having an alkoxy group as the silane compound, since this silane compound is hydrolyzed, an alcohol compound derived from the alkoxy group is contained in the liquid mixture. The hydrolysis reaction progresses even in metal oxide particle-adsorbed water and thus can occur in any of the step A to the step E. Therefore, in this case, an alcohol compound is contained in a dispersion liquid to be obtained unless a step of removing the alcohol compound is provided.

In the hydrolysis step, after being prepared, the hydrolyzed liquid may be held at a certain temperature that is randomly selected for a predetermined time. This makes it possible for the hydrolysis of the silane compound to be further accelerated.

In this treatment, the temperature of the hydrolyzed liquid is not particularly limited, can be randomly selected, and can be appropriately changed depending on the kind of the silane compound. For example, the temperature of the hydrolyzed liquid is preferably 5°C or higher and 65°C or lower, more preferably 20°C or higher and 65°C or lower, and still more preferably 30°C or higher and 60°C or lower. The temperature of the hydrolyzed liquid may be 40°C or higher and 75°C or lower or 50°C or higher and 70°C or lower as necessary.

In addition, the holding time at the above-described temperature is not particularly limited and is, for example, preferably 10 minutes or longer and 180 minutes or shorter and more preferably 30 minutes or longer and 120 minutes or shorter. The holding time may be 15 minutes or longer and 60 minutes or shorter or 20 minutes or longer and 40 minutes or shorter as necessary.

While the hydrolyzed liquid is being held, the hydrolyzed liquid may be appropriately stirred.

(Step B (mixing step))

In the mixing step, the silane compound and the metal oxide particles are mixed to obtain a liquid mixture. In the mixing step, water or a catalyst may be mixed in addition to the silane compound and the metal oxide particles. In the case of obtaining the hydrolyzed liquid by the above-described hydrolysis step, the liquid mixture is obtained by mixing the hydrolyzed liquid and the metal oxide particles.

In addition, the hydrolyzed liquid and the metal oxide particles are mixed such that the content of the metal oxide particles in the liquid mixture is 10% by mass or more and 49% by mass or less and the total content of the silane compound and the metal oxide particles is 65% by mass or more and 98% by mass or less.

As described above, in the present embodiment, the total content of the silane compound and the metal oxide particles in the liquid mixture is extremely large. In addition, an organic solvent or a dispersion medium such as water that has been considered as essential in the related art is not contained in the liquid mixture or is contained in an extremely small amount compared with the related art. Alternatively, a small amount of an unavoidable alcohol compound is contained due to the hydrolysis. Even in such a case, the dispersion step makes it possible for the metal oxide particles to be uniformly dispersed in the liquid mixture and makes the silane compound uniformly attached to the metal oxide particles (surface modification).

In more detail, generally, in a case where metal oxide particles are surface-modified with a surface-modifying material in a liquid phase, it is common to mix not only the metal oxide particles and the surface-modifying material but also a dispersion medium to obtain a liquid mixture and disperse the liquid mixture using a disperser. When the metal oxide particles which have been surface-modified by such a method are mixed with a methyl-based silicone resin, the metal oxide particles cannot be sufficiently dispersed in the methyl-based silicone resin and agglomerate, which has resulted in a problem of the occurrence of turbidity such as white turbidity in the methyl-based silicone resin. In such a case, the metal oxide particles that are added do not sufficiently exhibit intended performance.

The dispersion medium is usually added for the purpose of decreasing the viscosity of the liquid mixture, uniformly dispersing the metal oxide particles, and uniformly modifying the surfaces of the metal oxide particles with the surface-modifying material. In the related art, it has been considered that, in the case of not using a dispersion medium, the viscosity of the dispersion liquid increases, and consequently, the surface-modifying material is not sufficiently attached to the surfaces of the metal oxide particles. Surprisingly, the present inventors and the like found that it is possible to uniformly disperse metal oxide particles in a dispersion liquid to be obtained and uniformly modify the metal oxide particles with a silane compound by directly dispersing the metal oxide particles in a high concentration of the silane compound while using no dispersion medium or only a small amount of a dispersion medium that has been considered as essential in the related art as described above.

The silane compound has a low molecular weight and a relatively low viscosity. Furthermore, the silane compound is hydrolyzed in the hydrolysis step described above and thereby has a favorable property of being attached to the metal oxide particles. Therefore, the silane compound is extremely preferable for dispersion of the metal oxide particles in a high concentration of the surface-modifying material.

In a case where the total content of the silane compound and the metal oxide particles is less than 65% by mass, since the amount of components other than the above-described two components, for example, the dispersion medium becomes too large, it is not possible to sufficiently attach the silane compound to the surfaces of the metal oxide particles in the dispersion step (step C) to be described below. As a result, a large number of hydroxyl groups remain on the surfaces of the metal oxide particles, and, when a dispersion liquid that is obtained afterwards is mixed with a hydrophobic material, the metal oxide particles agglomerate, and the hydrophobic material becomes turbid. The total content of the silane compound and the metal oxide particles needs to be 65% by mass or more and is preferably 70% by mass or more and more preferably 75% by mass or more. The total content of the surface-modifying material and the inorganic particles may be 80% by mass or more, 85% by mass or more, 90% by mass or more, or 92% by mass or more as necessary.

In contrast, when the total content of the silane compound and the metal oxide particles exceeds 98% by mass, the viscosity of the liquid mixture becomes too high, and it is not possible to sufficiently attach the silane compound to the surfaces of the metal oxide particles in the dispersion step (step C) to be described below. The total content of the silane compound and the metal oxide particles needs to be 98% by mass or less and is preferably 97% by mass or less and more preferably 95% by mass or less. The total content of the surface-modifying material and the inorganic particles may be 90% by mass or less, 85% by mass or less, 80% by mass or less, or 75% by mass or less as necessary.

In addition, as described above, the content of the metal oxide particles in the liquid mixture is 10% by mass or more and 49% by mass or less. In this range, it is possible to control the amount of the silane compound with respect to the metal oxide particles to be within an appropriate range, to uniformly attach the silane compound to the surfaces of the metal oxide particles, and to suppress an increase in the viscosity of the liquid mixture.

On the other hand, in a case where the content of the metal oxide particles in the liquid mixture is less than 10% by mass, the amount of the silane compound becomes excessive with respect to the metal oxide particles, and the excess silane compound induces the agglomeration of the metal oxide particles in a dispersion liquid to be obtained. The content of the metal oxide particles in the liquid mixture is preferably 20% by mass or more, still more preferably 23% by mass or more, still more preferably 26% by mass or more, and more preferably, in particular, 30% by mass or more.

In addition, when the content of the metal oxide particles exceeds 49% by mass, the amount of the silane compound is insufficient with respect to the metal oxide particles, and a sufficient amount of the silane compound is not attached to the metal oxide particles. In addition, the content of the metal oxide particles becomes too large, consequently, the viscosity of the liquid mixture becomes too high, and it is not possible to sufficiently disperse the metal oxide particles in the dispersion step (step C) to be described below. The content of the metal oxide particles in the liquid mixture is preferably 45% by mass or less and more preferably 40% by mass or less. The amount is still more preferably 38% by mass or less and particularly preferably 36% by mass or less. The content of the metal oxide particles in the liquid mixture may be 34% by mass or less.

The content of the silane compound with respect to the content of the metal oxide particles in the liquid mixture is not particularly limited, but is, for example, preferably 100% by mass or more and 800% by mass or less, more preferably 140% by mass or more and 600% by mass or less, still more preferably 180% by mass or more and 400% by mass or less, and particularly preferably 200% by mass or more and 270% by mass or less with respect to the amount of the metal oxide particles. In such a case, it is possible to control the amount of the silane compound with respect to the metal oxide particles to be within an appropriate range and to uniformly attach the silane compound to the surfaces of the metal oxide particles.

In addition, in the mixing step, an organic solvent may be further mixed with the liquid mixture. When an organic solvent is mixed with the liquid mixture, it becomes possible to control the reactivity of the surface-modifying material, and it becomes possible to control the degree of attachment of the surface-modifying material to the surfaces of the metal oxide particles. Furthermore, it becomes possible to adjust the viscosity of the liquid mixture with the organic solvent.

Examples of such an organic solvent include the hydrophobic solvents or the hydrophilic solvents exemplified as the above-described dispersion medium of the dispersion liquid according to the present embodiment. These organic solvents may be used singly or two or more organic solvents may be used in combination.

The content of the organic solvent in the liquid mixture is not particularly limited as long as it satisfies the contents of the metal oxide particles and the silane compound are satisfied. It is needless to say that the organic solvent may not be contained in the liquid mixture.

The mixing time or mixing temperature in the mixing step can be randomly selected. For example, the mixing may be carried out at room temperature or the materials may be well mixed and then stirred for approximately 0 to 600 seconds.

(Step C (dispersion step))

In the dispersion step, the metal oxide particles are dispersed in the liquid mixture to obtain a first dispersion liquid in which the metal oxide particles are dispersed. In the present embodiment, the metal oxide particles are dispersed in a high concentration of the hydrolyzed silane compound. Therefore, in the first dispersion liquid to be obtained, the silane compound is relatively uniformly attached to the surfaces of the metal oxide particles, and the metal oxide particles are relatively evenly dispersed.

The metal oxide particles can be dispersed by a well-known dispersion method, for example, the use of a disperser. As the disperser, for example, a bead mill, a ball mill, a homogenizer, a disperser, a stirrer, or the like is preferably used. The step C is preferably a step of dispersing only the mixture obtained in the step B.

Here, in the dispersion step, the metal oxide particles are preferably dispersed in the liquid mixture by imparting the minimum necessary amount of energy without imparting excess energy such that the particle diameters (dispersed-particle diameters) of the metal oxide particles become almost uniform in the dispersion liquid.

The dispersion time can be randomly selected depending on conditions, may be, for example, 3 to 15 hours, and is preferably 4 to 12 hours and more preferably 5 to 10 hours. However, the dispersion temperature is not limited only thereto.

The dispersion temperature can be randomly selected, may be, for example, 10°C to 50°C, and is preferably 20°C to 40°C and more preferably 30°C to 40°C. However, the dispersion temperature is not limited only thereto.

A difference of the dispersion step C from the mixing step B is that the inorganic particles are continuously dispersed over a certain period of time.

(Step D (addition step (first addition step)))

In an addition step, a hydrophobic solvent is added to the first dispersion liquid obtained in the step C (dispersion step), and the first dispersion liquid is adjusted to a desired solid content (concentration).

The first dispersion liquid obtained in the dispersion step has a high solid content (concentration). Therefore, the viscosity is high, and the handleability is poor. However, when a hydrophobic solvent was simply added to the obtained first dispersion liquid in order to reduce the solid content, since the hydrophobicity of the surfaces of the particles was poor, the particles agglomerated, and a uniform dispersion liquid could not be obtained.

Therefore, as a result of studies, the present inventors and the like found that, when the obtained first dispersion liquid is heated, and a hydrophobic solvent is gradually added, it is possible to adjust the solid content of the dispersion liquid to be low. This operation makes it possible to obtain an extremely excellent effect.

The above-described mechanism is assumed as follows.

When the first dispersion liquid is heated, the polymerization of the silane compound attached to the metal oxide particles proceeds, and the hydrophobicity of the surfaces of the particles improves. Even when the polymerization reaction of the silane compound proceeds excessively, the metal oxide particles agglomerate. Therefore, a hydrophobic solvent is gradually added to the first dispersion liquid in which the polymerization reaction is in progress. Such addition makes the surfaces gradually hydrophobilized while suppressing an excessive polymerization reaction and makes it possible for the hydrophobic solvent to be gradually mixed.

That is, the hydrophobic solvent is added to an extent that the metal oxide particles do not agglomerate, and the polymerization reaction of the silane compound is made to proceed to an extent that the silane compound is compatible with the hydrophobic solvent added. This makes it possible to obtain a dispersion liquid having a solid content adjusted to a desired value.

As described above, the hydrophobic solvent needs to be added gradually so that the metal oxide particles do not agglomerate. Therefore, the hydrophobic solvent may be added after the first dispersion liquid obtained in the dispersion step is heated, the hydrophobic solvent may be added before the first dispersion liquid is heated, or the heating of the first dispersion liquid and the addition of the hydrophobic solvent may be carried out at the same time.

That is, more specifically, the addition step may be a step d1 of heating the first dispersion liquid and then adding the hydrophobic solvent at a rate at which the metal oxide particles do not agglomerate, may be a step d2 of adding the hydrophobic solvent at a rate at which the metal oxide particles do not agglomerate while heating the first dispersion liquid, or may be a step d3 of adding the hydrophobic solvent at a rate at which the metal oxide particles do not agglomerate and then heating the first dispersion liquid.

In the step d1, at the time of adding the metal oxide particles, the heating of the dispersion liquid may be continued or the heating may be stopped. The temperature of the dispersion liquid may be constant or the temperature of the dispersion liquid may be changed. The temperature is preferably maintained constant. In the step d2, at the time of adding the metal oxide particles, the temperature of the dispersion liquid may be constant or the temperature of the dispersion liquid may be changed.

The hydrophobic solvent may be added continuously or added intermittently two or more separate times. In the case of adding the hydrophobic solvent intermittently, the number of times of addition is not limited, but the hydrophobic solvent can be added, for example, 2 to 6 times or 3 to 5 times. When the hydrophobic solvent is added a plurality of times, the amount of the hydrophobic solvent added each time may be the same or changed.

The rate at which the metal oxide particles do not agglomerate is not particularly limited. The rate or proportion of the addition of the hydrophobic solvent can be randomly selected. For example, the hydrophobic solvent may be continuously added at an addition rate at which the solid content decreases in a range of 3% by mass or more and 20% by mass or less within 1 hour. In other words, after the hydrophobic solvent is continuously added for 1 hour, the difference in the solid content in the dispersion liquid before addition and after addition may be in a range of 3% by mass or more and 20% by mass or less. The amount of the hydrophobic solvent added needs to be appropriately adjusted so that the amount of the hydrophobic solvent added is large when the heating temperature is high and the amount of the hydrophobic solvent added is small when the heating temperature is low.

As described above, the rate or proportion of the addition of the hydrophobic solvent can be randomly selected. For example, the hydrophobic solvent needs to be added stepwise every 30 minutes, every hour, or every 2 hours so that the solid content decreases by a range of 3% by mass or more and 20% by mass or less. The amount of the hydrophobic solvent added needs to be appropriately adjusted so that the amount of the hydrophobic solvent added at one time is large when the heating temperature is high and the amount of the hydrophobic solvent added at one time is small when the heating temperature is low. In this case, the addition time or the number of times of addition of the hydrophobic solvent may be preferably adjusted.

The heating temperature is not particularly limited as long as the heating temperature is a temperature at which the polymerization reaction of the silane compound proceeds. The heating temperature is preferably, for example, 35°C or higher and 80°C or lower. The heating temperature may be 40°C or higher and 75°C or lower, 45°C or higher and 70°C or lower, or 50°C or higher and 65°C or lower. When the heating temperature is 35°C or higher, it is possible to make the polymerization reaction of the silane compound proceed. On the other hand, when the heating temperature is 80°C or lower, it is possible to suppress the agglomeration of the metal oxide particles due to a rapid reaction of the silane compound.

The heating time needs to be appropriately carried out until the adjustment of the solid content is over. For example, the heating time is preferably 4 hours or longer and 12 hours or shorter. When the heating time is 4 hours or longer, the polymerization reaction of the silane compound proceeds, and it becomes possible to mix the silane compound with the hydrophobic solvent. On the other hand, when the heating time is 12 hours or shorter, it is possible to suppress the agglomeration of the metal oxide particles due to the excessive progress of the polymerization reaction of the silane compound.

The hydrophobic solvent is not particularly limited as long as the hydrophobic solvent is compatible with materials that need to be mixed with the dispersion liquid of the present embodiment. Examples of the hydrophobic solvents include aromatic solvents, saturated hydrocarbons, unsaturated hydrocarbons, and the like. These hydrophobic solvents may be used singly or two or more hydrophobic solvents may be used in combination. Among these, the aromatic solvents, particularly, aromatic hydrocarbons are preferable. The aromatic solvents have excellent compatibility with the methyl-based silicone resin and thereby contribute to improvement in the viscosity characteristics of compositions to be obtained and improvement in the qualities (transparency, shape, and the like) of sealing members to be formed.

Examples of the aromatic hydrocarbons include benzene, toluene, ethylbenzene, 1-phenylpropane, isopropylbenzene, n-butylbenzene, tert-butylbenzene, sec-butylbenzene, o-xylene, m-xylene, p-xylene, 2-ethyltoluene, 3-ethyltoluene, 4-ethyltoluene, and the like. These aromatic hydrocarbons may be used singly or two or more aromatic hydrocarbons may be used in combination.

Among these, from the viewpoint of the stability of the dispersion liquid and easiness in handleability in the removal of the dispersion medium or the like during the production of a composition to be described below, as the aromatic hydrocarbon, at least one selected from the group consisting of toluene, o-xylene, m-xylene, p-xylene, and benzene is particularly preferably used.

The content of the hydrophobic solvent contained in the final dispersion liquid needs to be appropriately adjusted so as to obtain a desired solid content. The content of the hydrophobic solvent is, for example, preferably 40% by mass or more and 95% by mass or less, more preferably 50% by mass or more and 90% by mass or less, and still more preferably 60% by mass or more and 80% by mass or less.

The first addition step makes it possible to obtain a second dispersion liquid having a solid content adjusted to a desired value. The use of the second dispersion liquid improves the handleability of the dispersion liquid in the following steps.

(Step F (removal step))

In the present embodiment, a step F of removing an alcohol generated by hydrolysis may be provided between the step D and the step E.

It is assumed that the provision of the removal step improves the production efficiency of the steps to be described below.

A removal method is not particularly limited, and, for example, an evaporator can be used. The removal step may be carried out until the alcohol is completely removed or about 5% by mass of the alcohol may remain.

(Step E (second addition step))

Next, the metal oxide particles are treated with a silicone compound to obtain a third dispersion liquid. As described above, in the dispersion step, the silane compound is relatively uniformly attached to the surfaces of the metal oxide particles. Therefore, the silicone compound can be relatively uniformly attached to the surfaces of the metal oxide particles through the silane compound.

In the second addition step, first, the second dispersion liquid and a silicone compound are mixed to obtain a treatment liquid. Next, the treatment liquid may be held at a constant temperature for a predetermined time. This makes it possible to further accelerate the attachment of the silicone compound to the metal oxide particles.

Examples of the silicone compound include the above-described silicone compounds. These silicone compounds may be used singly or two or more silicone compounds may be used in combination.

The silicone compound can be added to and mixed with the second dispersion liquid such that the content of the silicone compound in the third dispersion liquid, for example, preferably becomes 50% by mass or more and 500% by mass or less, more preferably becomes 80% by mass or more and 400% by mass or less, and far more preferably becomes 100% by mass or more and 300% by mass or less with respect to the metal oxide particles. In such a case, it is possible to attach a sufficient amount of the silicone compound to the surfaces of the metal oxide particles and to improve the dispersion stability of the metal oxide particles and improve the dispersibility into the methyl-based silicone resin. Furthermore, it is possible to reduce the amount of the silicone compound isolated and to suppress unintended agglomeration of the metal oxide particles in the methyl-based silicone resin.

In the second addition step, the holding temperature is not particularly limited and can be appropriately changed depending on the kind of the silicone compound, but is, for example, preferably 40°C or higher and 130°C or lower and more preferably 50°C or higher and 120°C or lower.

In addition, the holding time is not particularly limited, but is, for example, preferably 1 hour or longer and 24 hours or shorter and more preferably 2 hours or longer and 20 hours or shorter.

During the above-described holding, the second dispersion liquid may be appropriately stirred.

In addition, in the second addition step, the treatment with the silicone compound may be carried out a plurality of times. For example, when the treatment with the silicone compound is carried out a plurality of times using different kinds of silicone compounds, the control of the surface state of the metal oxide particles in accordance with the kind of the methyl-based silicone resin becomes easier.

In addition, in the second addition step, the hydrophobic solvent may be added so as to obtain a desired solid content by measuring the solid content after the treatment with the silicone compound. When the solid content is decreased, the mixing with a sealing resin to be described below becomes easy.

As described above, the metal oxide particles are treated with the silicone compound, and the third dispersion liquid can be obtained.

In the dispersion liquid produced using the method for producing a dispersion liquid according to the present embodiment, the metal oxide particles are uniformly dispersed, and the surfaces of the metal oxide particles are uniformly and sufficiently modified with the silane compound and the silicone compound. In addition, the metal oxide particles modified as described above have an excellent affinity to the methyl-based silicone resin and can be relatively uniformly dispersed in the methyl-based silicone resin. Therefore, even in a case where the metal oxide particles are dispersed in the methyl-based silicone resin, the occurrence of turbidity such as white turbidity is suppressed. Furthermore, a change in the viscosity of the methyl-based silicone resin containing the metal oxide particles is also suppressed.

Components other than the components described above, for example, general additives such as a dispersant, a dispersion aid, an antioxidant, a flow adjuster, a viscosity improver, a pH adjuster, and a preservative may be mixed with the dispersion liquid according to the present embodiment as necessary. These are added in a random step as necessary.

As described above, in the dispersion liquid of the present embodiment, it has become possible to mix the metal oxide particles with a hydrophobic material by directly dispersing the metal oxide particles in the silane compound. It is assumed that a large amount of the silane compound is attached to the metal oxide particles and dense coatings are formed compared with dispersion liquids of the related art.

It is not clear what state the surfaces of the metal oxide particles are in, which made it possible for the dispersion liquid to be mixed with the hydrophobic material. Therefore, It is difficult to directly specify the characteristics of the dispersion liquid of the present embodiment with the state of the surfaces of the metal oxide particles modified with the silane compound and the silicone compound.

It is not easy to collectively specify by wording the state of the surfaces for enabling the mixing of the metal oxide particles with the hydrophobic material in a case where the dispersion liquid contains the metal oxide particles, one or more silane compounds and one or more silicone compounds at least a part of which is attached to the metal oxide particles, and the hydrophobic solvent. This is because that fact that the metal oxide particles can be well mixed with the hydrophobic material is assumed to be developed by the complex entanglement of a number of factors, such as the structures of the silane compound and the silicone compound, the degree of polymerization in the dispersion liquid, and the characteristics of the metal oxide particles. However, the present invention has made it possible to provide a dispersion liquid having an excellent effect.

<4. Composition>

Next, a composition according to the present embodiment will be described.

The composition according to the present embodiment is a mixture of the above-described dispersion liquid and a resin component. Therefore, the composition according to the present embodiment contains a resin component, that is, at least one of a resin and a precursor thereof in addition to the above-described metal oxide particles which have been surface-modified with the silane compound and the silicone compound.

The composition according to the present embodiment can be used as a sealing member for light-emitting elements by being cured as described below. The composition according to the present embodiment contains the above-described metal oxide particles contributing to improvement in the refractive index and transparency and is thus capable of improving the brightness of light of light-emitting devices when being used for sealing members.

Furthermore, the composition according to the present embodiment contains metal oxide particles which have been surface-modified with the above-described silane compound and silicone compound. Therefore, even when a methyl-based silicone resin is contained as the resin component, the agglomeration of the metal oxide particles is suppressed and the deterioration of transparency is suppressed. Therefore, it is possible to improve the brightness of light of light-emitting devices at the time of using the composition according to the present embodiment for sealing members.

The content of the metal oxide particles in the composition of the present embodiment can be randomly selected. From the viewpoint of obtaining a highly transparent composition, the amount is preferably 5% by mass or more and 50% by mass or less, more preferably 5% by mass or more and 40% by mass or less, and still more preferably 10% by mass or more and 35% by mass or less. The content of the metal oxide particles may be 1% by mass or more and 20% by mass or less or 3% by mass or more and 15% by mass or less as necessary.

In addition, the content of the surface-modifying material such as the silane compound and the silicone compound in the composition can correspond to the content in the dispersion liquid according to the present embodiment.

The resin component is a main component in the composition according to the present embodiment. The resin component is cured to seal light-emitting elements when the composition according to the present embodiment is used as a sealing material. As a result, the resin component prevents deterioration factors from external environments such as moisture and oxygen from reaching the light-emitting elements. In addition, in the present embodiment, a cured product that is obtained from the resin component is basically transparent and is capable of transmitting light that is emitted from light-emitting elements.

Such a resin component is not particularly limited as long as the resin component can be used as a sealing material. For example, resins such as a silicone resin or an epoxy resin may be used singly or two or more resins may be used in combination. In particular, from the viewpoint of durability, a silicone resin, particularly, a methyl-based silicone resin is preferable.

As the methyl-based silicone resin, for example, a dimethyl-based silicone resin, a methyl phenyl silicone resin, or the like can be used.

The content of the methyl-based silicone resin in the resin component needs to be adjusted depending on desired characteristics and is not particularly limited. For example, the proportion may be 100% by mass, may be 20% by mass or more and 80% by mass or less, may be 30% by mass or more and 70% by mass or less, or may be 40% by mass or more and 60% by mass or less. In the related art, when metal oxide particles are contained in the methyl-based silicone resin, the metal oxide particles agglomerate, the transparency deteriorates, and the refractive index does not sufficiently improve. In contrast, the composition according to the present embodiment contains metal oxide particles which have been surface-modified with the above-described silane compound and silicone compound. Therefore, even when the methyl-based silicone resin is contained as the resin component in a large amount as described above, the agglomeration of the metal oxide particles is suppressed and the deterioration of transparency is suppressed. In addition, since it becomes possible to employ the methyl-based silicone resin, the durability of sealing members that are formed using the composition improves.

The structure of the resin component may be a two-dimensional chain-like structure, may be a three-dimensional net-like structure, or may be a basket-like structure.

The resin component needs to be in a cured polymer form when used as a sealing member. In the composition, the resin component may be in an uncured state, that is, may be a precursor. Therefore, the resin component that is present in the composition may be, for example, a monomer, may be an oligomer, or may be a polymer.

As the resin component, an addition reaction-type resin may be used, a condensation reaction-type resin may be used, or a radical polymerization reaction-type resin may be used.

The viscosity of the resin component at 25°C, which is measured according to JIS Z 8803:2011, is, for example, preferably 10 mPa·s or more and 100,000 mPa·s or less, more preferably 100 mPa·s or more and 10,000 mPa·s or less, and still more preferably 1,000 mPa·s or more and 7,000 mPa·s or less.

In addition, the content of the resin component in the composition according to the present embodiment can be set to be the remainder of the other components and is, for example, preferably 10% by mass or more and 70% by mass or less.

The mass ratio of the resin component to the surface-modified metal oxide particles in the composition according to the present embodiment can be randomly selected and is, for example, preferably in a range of 50:50 to 90:10 and more preferably in a range of 60:40 to 80:20 (resin component : surface-modified metal oxide particles).

The dispersion medium derived from the dispersion liquid according to the present embodiment may be contained in or removed from the composition according to the present embodiment. That is, the dispersion medium derived from the dispersion liquid may be completely removed. The dispersion medium may remain in the composition in an amount of approximately 1% by mass or more and 10% by mass or less or may remain in an amount of approximately 2% by mass or more and 5% by mass or less.

In addition, the composition according to the present embodiment may contain the particles of a fluorescent body as long as the object of the present invention is not impaired. The particles of a fluorescent body absorb light having a specific wavelength that is emitted from light-emitting elements and release light having a predetermined wavelength. That is, it becomes possible to convert the wavelength of light and, furthermore, adjust the color tone with the particles of a fluorescent body.

The particles of a fluorescent body are not particularly limited as long as the particles can be used light-emitting devices as described below, can be randomly selected, and can be appropriately selected and used such that the color of light emitted from light-emitting devices becomes a desired color.

The content of the particles of a fluorescent body in the composition according to the present embodiment can be appropriately adjusted and used such that a desired brightness can be obtained.

In addition, the composition according to the present embodiment may also contain an additive that is generally used such as a preservative, a polymerization initiator, a polymerization inhibitor, a curing catalyst, or a light scattering agent as long as the object of the present invention is not impaired. As the light scattering agent, silica particles having an average particle diameter of 1 um to 30 um are preferably used.

The composition according to the present embodiment can be produced by mixing the dispersion liquid according to the present embodiment and the resin component. In addition, after the mixing, the dispersion medium contained in the dispersion liquid may be removed with an evaporator or the like as necessary.

The composition according to the present embodiment contains the metal oxide particles which have been surface-modified with the above-described silane compound and silicone compound. As a result, even when the methyl-based silicone resin is contained as the resin component, the agglomeration of the metal oxide particles is suppressed and the deterioration of transparency is suppressed. Therefore, it is possible to form sealing members that improve the brightness of light of light-emitting devices using the composition according to the present embodiment.

The methyl-based silicone resin used in the above description may mean, for example, a methyl-based silicone resin in which a siloxane bond that alternately bonds silicon and oxygen is present as a main skeleton and a number of functional groups that bond to Si atoms, for example, 60% or more, preferably, 80% or more of functional groups are methyl groups. However, the methyl-based silicone resin is not limited only to this example.

<5. Sealing member>

A sealing member according to the present embodiment is a cured product of the composition according to the present embodiment. The sealing member according to the present embodiment is generally used as a sealing member that is disposed on light-emitting elements or a part thereof.

The thickness or shape of the sealing member according to the present embodiment can be appropriately adjusted depending on desired uses or characteristics and is not particularly limited.

The sealing member according to the present embodiment can be produced by curing the composition according to the present embodiment as described above. A method for curing the composition can be selected depending on the characteristics of the resin component in the composition according to the present embodiment. Examples thereof include thermal curing, electron beam curing, and the like. When described more specifically, the sealing member of the present embodiment can be obtained by curing the resin component in the composition according to the present embodiment by an addition reaction or a polymerization reaction.

The average dispersed-particle diameter of the metal oxide particles in the sealing member is preferably 10 nm or more and 300 nm or less, more preferably 20 nm or more and 250 nm or less, and still more preferably 30 nm or more and 200 nm or less.

The average dispersed-particle diameter of the metal oxide particles in the sealing member is a number distribution-based average particle diameter (median diameter) which is measured by the transmission electron microscopic observation (TEM) of the sealing member. In addition, the average dispersed-particle diameter of the metal oxide particles in the sealing member according to the present embodiment is a value that is measured and calculated based on the dispersed-particle diameters of the metal oxide particles in the sealing member. The average dispersed-particle diameter is measured and calculated based on the diameters of the metal oxide particles in a dispersed state regardless of whether the metal oxide particles are in a primary particle or secondary particle state. In addition, in the present embodiment, the average particle diameter of the metal oxide particles in the sealing member may be measured as the average particle diameter of the metal oxide particles to which the surface-modifying material to be described below has been attached. In the sealing member, the metal oxide particles to which the surface-modifying material has been attached and the metal oxide particles to which the surface-modifying material is not attached can be present. Therefore, usually, the average particle diameter of the metal oxide particles in the sealing member is measured as a value in a mixed state thereof.

The sealing member according to the present embodiment is a cured product of the composition according to the present embodiment and is thus excellent in terms of the refractive index and transparency. Therefore, according to the present embodiment, it is possible to obtain a sealing member having an excellent extraction efficiency that improves the brightness of light of light-emitting devices.

<6. Light-emitting device>

Next, a light-emitting device according to the present embodiment will be described. The light-emitting device according to the present embodiment includes the above-described sealing member and a light-emitting element sealed with the sealing member.

Examples of the light-emitting element include a light-emitting diode (LED), an organic light-emitting diode (OLED), and the like. Particularly, the sealing member according to the present embodiment is suitable for the sealing of light-emitting diodes.

Hereinafter, the light-emitting device according to the present embodiment will be described using an example in which the light-emitting element is a light-emitting diode on a chip, that is, an LED chip, and the light-emitting device is an LED package.

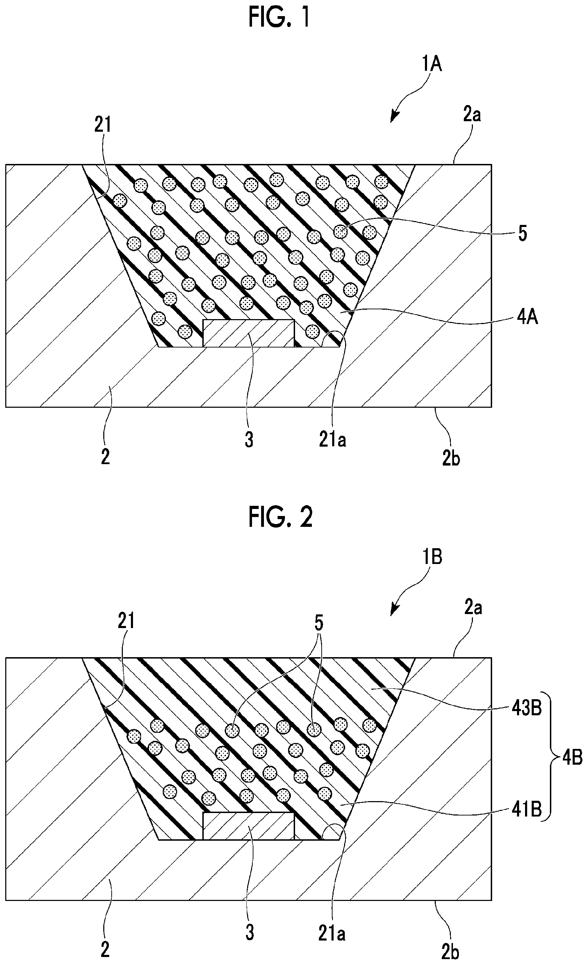

FIG. 1 to FIG. 4 each are schematic views (cross-sectional views) showing examples of the light-emitting device according to the embodiment of the present invention.

The sizes of individual members in the drawings are appropriately stressed in order to facilitate the description and do not indicate actual dimensions and ratios between the members. In the present specification and the drawings, configurational elements having substantially the same functional configuration will be given the same reference sign and will not be described again.

A light-emitting device (LED package) 1A shown in FIG. 1 includes a substrate 2 having a recess portion 21, a light-emitting element (LED chip) 3 that is disposed on a bottom surface of the recess portion 21 of the substrate 2, and a sealing member 4A that seals and covers the light-emitting element 3 in the recess portion 21.

The sealing member 4A is configured using the above-described sealing member according to the present embodiment. Therefore, in the sealing member 4A, the above-described metal oxide particles derived from the compo-

EP 4 129 921 A1

sition according to the present embodiment are dispersed, and, consequently, the extraction efficiency of light in the light-emitting device 1A improves. In addition, particles of a fluorescent body 5 are dispersed in the sealing member 4A. The particles of a fluorescent body 5 convert the wavelength of at least a part of light that is released from the light-emitting element 3.

A light-emitting device 1B shown in FIG. 2 is different from the light-emitting device 1A in terms of the fact that a sealing member 4B forms two layers. That is, the sealing member 4B has a first layer 41B that directly covers the light-emitting element 3 and a second layer 43B that covers the first layer 41B. The first layer 41B and the second layer 43B are both the sealing member according to the present embodiment. The particles of a fluorescent body 5 are dispersed in the first layer 41B. On the other hand, the second layer 43B does not include the particles of a fluorescent body 5. In the light-emitting device 1B, the above-described metal oxide particles derived from the composition according to the present embodiment are dispersed in the first layer 41B and the second layer 43B that configure the sealing member 4B, whereby the brightness of light improves.

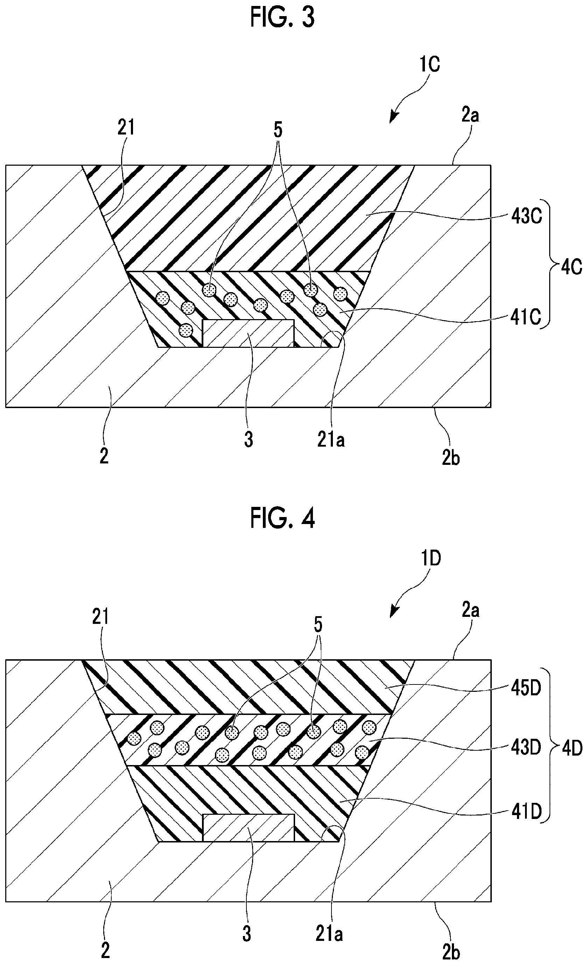

A light-emitting device 1C shown in FIG. 3 is also different from the light-emitting device 1A in terms of the fact that the configuration of a sealing member 4C is different from that of the sealing member 4A. The sealing member 4C has a first layer 41C that directly covers the light-emitting element 3 and a second layer 43C that covers the first layer 41C. The first layer 41C is not the sealing member according to the present embodiment, is a sealing member of a resin not containing the above-described metal oxide particles, and is configured using a resin or the like that can be used for sealing members. In addition, the particles of a fluorescent body 5 are dispersed in the first layer 41C. On the other hand, the second layer 43C is the sealing member according to the present embodiment. In the light-emitting device 1C, the above-described metal oxide particles derived from the composition according to the present embodiment are dispersed in the second layer 43C that configures the sealing member 4C, whereby the extraction efficiency of light improves.

In a light-emitting device 1D shown in FIG. 4, a sealing member 4D has a first layer 41D that directly covers the light-emitting element 3, a second layer 43D that covers the first layer 41D, and a third layer 45D that further covers the second layer 43D. The first layer 41D and the second layer 43D are not the sealing member according to the present embodiment, are a sealing member of a resin not containing the above-described metal oxide particles, and are configured using a resin or the like that can be used for sealing members. In addition, the particles of a fluorescent body 5 are dispersed in the second layer 43D. On the other hand, the third layer 45D is the sealing member according to the present embodiment. In the light-emitting device 1D, the above-described metal oxide particles derived from the composition according to the present embodiment are dispersed in the third layer 45D that configures the sealing member 4D, whereby the brightness of light improves.

The light-emitting device according to the present embodiment is not limited to the aspects shown in the drawings. For example, the light-emitting device according to the present embodiment may not include the particles of a fluorescent body in the sealing member. In addition, the sealing member according to the present embodiment can be present in a random location in the sealing member.

In the light-emitting device according to the present embodiment, since the light-emitting element is sealed with the sealing member of the present embodiment, the brightness of light improves.

In addition, in the light-emitting device according to the present embodiment, the light-emitting element is sealed with the above-described composition according to the present embodiment. Therefore, the present invention also relates to a method for producing a light-emitting device, the method having a step of sealing a light-emitting element using the composition according to the present embodiment in a sense. In the same sense, the above-described production method may also have a step of mixing the dispersion liquid according to the present embodiment and a resin component to obtain the composition.

The light-emitting element can be sealed by, for example, imparting the composition according to the present embodiment onto the light-emitting element using a dispenser or the like and then curing the composition.

<7. Illumination tool and display device>

The above-described light-emitting device according to the present embodiment can be used in, for example, illumination tools and display devices. Therefore, the present invention also relates to an illumination tool or a display device including the light-emitting device according to the present embodiment in a sense.

Examples of the illumination tool include an ordinary illumination tool such as an indoor lamp or an outdoor lamp, an illumination in a switch portion of an electronic device such as a mobile phone or OA equipment, and the like.

Since the illumination tool according to the present embodiment includes the light-emitting device according to the present embodiment, even when the same light-emitting element is used, the luminous flux being emitted becomes large compared with that in the related art, and it is possible to make the ambient environment brighter.

Examples of the display device include a mobile phone, a mobile information terminal, an electronic dictionary, a digital camera, a computer, a television, a peripheral device thereof, and the like.

21

Since the display device according to the present embodiment includes the light-emitting device according to the present embodiment, even when the same light-emitting element is used, the luminous flux being emitted becomes large compared with that in the related art, and it is possible to carry out displaying, for example, in a clearer and brighter manner.

Examples

Hereinafter, the present invention will be described in more detail using examples and comparative examples. The examples to be described below are simply examples of the present invention and do not limit the present invention.

[Example 1]

(1. Production of dispersion liquid)

(i) Hydrolysis step

90.78 Parts by mass of methyltrimethoxysilane (product name: KBM-13, manufactured by Shin-Etsu Chemical Co., Ltd.), 9.21 parts by mass of water, and 0.01 parts by mass of hydrochloric acid (1N) were prepared. These were added to a container and mixed together to obtain a hydrolyzed liquid. Next, this hydrolyzed liquid was stirred at 60°C for 30 minutes, and a hydrolysis treatment of methyltrimethoxysilane was carried out, thereby obtaining a hydrolyzed liquid.

(ii) Mixing step (step B)

30 Parts by mass of zirconium oxide ($ZrO_2$) particles having an average primary particle diameter of 12 nm (manufactured by Sumitomo Osaka Cement Co., Ltd.) and 70 parts by mass of the hydrolyzed liquid were mixed to obtain a liquid mixture. The content of the zirconium oxide particles in the liquid mixture was 30% by mass, the content of methyltrimethoxysilane was 63.5% by mass, and the total content of the zirconium oxide particles and methyltrimethoxysilane was 93.5% by mass.

(iii) Dispersion step (step C)

After this liquid mixture was dispersed in a bead mill for 6 hours, beads were removed, and a first dispersion liquid was obtained.
As a result of measuring the solid content of the first dispersion liquid (residual component after being heated at 100°C for 1 hour), the solid content was 70% by mass.

(iv) First addition step (step D)

The obtained first dispersion liquid was heated at 60°C for 2 hours. Next, toluene was added to the dispersion liquid such that the solid content became 40% by mass, and the dispersion liquid was heated at 60°C for 2 hours.
Next, toluene was added to the dispersion liquid such that the solid content became 30% by mass, and the dispersion liquid was heated at 60°C for 1 hour.
Next, toluene was added to the dispersion liquid such that the solid content became 20% by mass, and the dispersion liquid was heated at 60°C for 1 hour, thereby obtaining a second dispersion liquid.

(v) Second addition step (step E)

88.1 parts by mass of the second dispersion liquid having a solid content adjusted to 20% by mass with toluene and 11.9 parts by mass of a methoxy group-containing phenyl silicone resin (trade name: KR217, manufactured by Shin-Etsu Chemical Co., Ltd.) were mixed to obtain a treatment liquid, and then this treated liquid was heated at 110°C for 1 hour, thereby obtaining a dispersion liquid (third dispersion liquid) according to Example 1.

(2. Evaluation of dispersion liquid)

(i) Particle size distribution

A part of the obtained dispersion liquid according to Example 1 was collected, and D10, D50, and D90 of the zirconium oxide particles in the dispersion liquid having a solid content adjusted to 5% by mass with toluene were measured using a particle size distribution meter (model No.: SZ-100SP, manufactured by HORIBA, Ltd.) As a result, D10 was 104 nm, D50 was 122 nm, and D90 was 143 nm. It is conceivable that the particles that were contained in the dispersion liquid were basically only zirconium oxide particles to which a surface-modifying material (methyltrimethoxysilane or methoxy group-containing phenyl silicone resin) was attached. From this fact, the measured D10, D50, and D90 were considered as the D10, D50, and D90 of the surface-modified zirconium oxide particles.

(ii) FT-IR analysis

10 g of the dispersion liquid according to Example 1 having a solid content adjusted to 30% by mass with toluene was dried under conditions of 100°C and 20 hPa for 2 hours using a vacuum dryer (manufactured by EYELA Tokyo Rikakikai Co., Ltd., device name: VACUUM OVEN VOS-201SD). Next, 0.01 g to 0.05 g of the obtained metal oxide particles were used, and the transmission spectrum in a wavenumber range of 800 $cm^{-1}$ or more and 3800 $cm^{-1}$ or less was measured with a Fourier transform infrared spectrophotometer (model No.: FT/IR-670 Plus, manufactured by JASCO Corporation). The spectrum values were standardized such that the maximum value of the spectrum in this measurement range became 100 and the minimum value became 0, and the value (IA) at 3,500 $cm^{-1}$ and the value (IB) at 1,100 $cm^{-1}$ were obtained. As a result, the IA was 50.3, the IB was 25.5, and the IA/IB was 2.0. The results are shown in Table 1.

(3. Production of composition)

5.0 g of the dispersion liquid according to Example 1 having a solid content adjusted to 30% by mass with toluene was mixed with 3.5 g of methyl phenyl silicone (trade name: KER-2500-B, manufactured by Shin-Etsu Chemical Co., Ltd.). That is, the dispersion liquid and methyl phenyl silicone were mixed such that the mass ratio of the total mass of zirconia and the surface-modifying material to methyl phenyl silicone became 30:70.
Next, toluene was removed from this liquid mixture with an evaporator, thereby obtaining a composition according to Example 1.
The appearance of the obtained composition according to Example 1 was visually observed. As a result, the composition was transparent. As a result, it was possible to confirm that, in the composition, agglomeration of the zirconium oxide particles was suppressed and the zirconium oxide particles were relatively uniformly dispersed.

(Evaluation of stability of composition)

The viscosity of the composition according to Example 1 was measured using a rheometer (trade name: RHEOSTRESS RS-6000, manufactured by HAAKE) under conditions of 25°C and a shear rate of 1 (1/s).
As a result, the viscosity was 6.5 Pa·s.
This composition was stored at room temperature (25°C), and the viscosity was measured after 1 month. As a result, the viscosity of the composition was 85.4 Pa·s. The viscosity was increased, but was not high enough to withstand practical use. From this fact, it was possible to confirm that, in the composition, the zirconium oxide particles remained stably dispersed for a long period of time.

(4. Production of LED package and evaluation of brightness)

14 parts by mass of a methyl phenyl silicone resin (trade name: KER-2500-A/B, manufactured by Shin-Etsu Chemical Co., Ltd.) was added to 1 part by mass of the composition according to Example 1, adjustment was made such that 2% by mass of the surface-modified zirconium oxide particles were contained in the composition, and the components were mixed together. A composition obtained by mixing 0.38 parts by mass of the particles of a fluorescent body (yttrium aluminum garnet : YAG) with 1 part by mass of this composition (total amount of surface-modified zirconium oxide particles and resin : particles of a fluorescent body = 100:38) was loaded into an LED lead frame in a thickness of 300 um. After that, the composition was held at room temperature for 3 hours. Next, the composition was slowly heated and cured to form a sealing member, thereby producing a white LED package.
The brightness of the obtained white LED package was measured by applying a voltage of 3 V and an electric current of 150 mA to the LED package with a total luminous flux measurement system (manufactured by Otsuka Electronics Co., Ltd.) and measuring the intensity of light. As a result, the brightness of this white LED package was 74.2 lm.

[Example 2]

(1. Production of dispersion liquid)

A dispersion liquid (third dispersion liquid) according to Example 2 was obtained in the same manner as in Example 1 except that, instead of the zirconium oxide particles having an average primary particle diameter of 12 nm, zirconium oxide particles having an average primary particle diameter of 90 nm (manufactured by Sumitomo Osaka Cement Co., Ltd.) were used. The content of the zirconium oxide particles in the liquid mixture obtained in the mixing step was 30% by mass, the content of methyltrimethoxysilane was 63.5% by mass, and the total content of the zirconium oxide particles and methyltrimethoxysilane was 93.5% by mass.

As a result of measuring the solid content of the first dispersion liquid (residual component after being heated at 100°C for 1 hour), the amount of the solid content was 70% by mass.

(Particle size distribution of first dispersion liquid)

(i) Particle size distribution

The particle size distribution of the zirconium oxide particles in the dispersion liquid according to Example 2 was evaluated in a dispersion liquid having a solid content adjusted to 5% by mass with toluene in the same manner as in Example 1. As a result, D10 was 118 nm, D50 was 151 nm, and D90 was 298 nm.

(ii) FT-IR analysis

Furthermore, as a result of carrying out FT-IR analysis in the same manner as in Example 1 on the dispersion liquid according to Example 2, the IA was 48.4, the IB was 24.8, and the IA/IB was 2.0.

(3. Production of composition)

The dispersion liquid according to Example 2 having a solid content adjusted to 30% by mass with toluene was mixed with methyl phenyl silicone in the same manner as in Example 1, and toluene was removed, thereby obtaining a composition according to Example 2. As a result of visually observing the appearance of the obtained composition, the composition was transparent.

(Evaluation of stability of composition)

The viscosity of the composition was measured in the same manner as in Example 1. As a result, the viscosity immediately after the production was 5.5 Pa·s.

This composition was stored at room temperature (25°C), and the viscosity was measured after 1 month. As a result, the viscosity of the composition was 69.7 Pa·s, which showed that the viscosity increased but was low enough to withstand practical use.

A white LED package was produced in the same manner as in Example 1 except that the composition according to Example 2 was used instead of the composition according to Example 1. As a result, the brightness of this white LED package was 73.9 lm.

[Comparative Example 1]

(1. Production of dispersion liquid)

The mixing step (step B) and the dispersion step (step C) were carried out in the same manner as in Example 1 except that, in the mixing step (step B), 20 parts by mass of the hydrolyzed liquid and 50 parts by mass of isopropyl alcohol (IPA) were used instead of 70 parts by mass of the hydrolyzed liquid, thereby obtaining a dispersion liquid (first dispersion liquid).

As a result of measuring the solid content of the dispersion liquid (at 100°C for 1 hour), the solid content was 38% by mass.

(iv) First addition step

Toluene was added to the obtained dispersion liquid (first dispersion liquid) such that the solid content became 20% by mass, and the dispersion liquid was heated at 60°C for 2 hours. Next, about the same amount of toluene as the volatilized amount was added to the dispersion liquid, and the dispersion liquid was heated at 60°C for 2 hours. Next, about the same amount of toluene as the volatilized amount was added to the dispersion liquid, and the dispersion liquid was heated at 60°C for 1 hour. Next, about the same amount of toluene as the volatilized amount was added to the dispersion liquid, and the dispersion liquid was heated at 60°C for 1 hour. The dispersion liquid was heated for 6 hours in the above-described manner, whereby surface modification was accelerated, and a dispersion liquid (second dispersion liquid) in which isopropyl alcohol was replaced with toluene was obtained.

(v) Second addition step

88.1 parts by mass of the second dispersion liquid having a solid content adjusted to 20% by mass and 11.9 parts by mass of a methoxy group-containing phenyl silicone resin (trade name: KR217, manufactured by Shin-Etsu Chemical Co., Ltd.) were mixed to obtain a treatment liquid, and this treated liquid was heated at 110°C for 1 hour, thereby obtaining a dispersion liquid (third dispersion liquid) according to Comparative Example 1.

The particle size distribution of the zirconium oxide particles in the dispersion liquid according to Comparative Example 1 was evaluated in a dispersion liquid having a solid content adjusted to 5% by mass with toluene in the same manner as in Example 1. As a result, D10 was 91 nm, D50 was 112 nm, and D90 was 136 nm.

Furthermore, on the dispersion liquid according to Comparative Example 1 having a solid content adjusted to 30% by mass with toluene, FT-IR analysis was carried out in the same manner as in Example 1. As a result, the IA was 42.1, the IB was 10.0, and the IA/IB was 4.2.

The dispersion liquid according to Comparative Example 1 having a solid content adjusted to 30% by mass with toluene was mixed with methyl phenyl silicone in the same manner as in Example 1, and toluene was removed, thereby obtaining a composition according to Comparative Example 1. As a result, the composition according to Comparative Example 1 became white turbid, and it was not possible to obtain a composition capable of sealing LEDs.

The production conditions of the dispersion liquids, the dispersion liquids, and the evaluations of the compositions in Example 1, Example 2, and Comparative Example 1 are summarized in Table 1.

[Table 1]

| | Average primary particle diameter of ZrO$_2$ particles [nm] | Content of ZrO$_2$ particles [parts by mass] | Content of hydrolyzed liquid [parts by mass] | Particle size distribution | | | FT-IR analysis | | | Viscosity of composition | | Brightness of LED package [lm] |
| | | | | D10 [nm] | D50 [nm] | D90 [nm] | IA | IB | IA/IB | Immediately after production [Pa·s] | After 1 month [Pa·s] | |
|---|---|---|---|---|---|---|---|---|---|---|---|---|
| Example 1 | 12 | 30 | 70 | 104 | 122 | 143 | 50.3 | 25.5 | 2.0 | 6.5 | 85.4 | 74.2 |
| Example 2 | 90 | 30 | 70 | 118 | 151 | 298 | 48.4 | 24.8 | 2.0 | 5.5 | 69.7 | 73.9 |
| Comparative Example 1 | 12 | 30 | 20 Parts by mass of hydrolyzed liquid/50 parts by mass of IPA | 91 | 112 | 136 | 42.1 | 10.0 | 4.2 | - | - | - |

[Reference Example]

A white LED package containing no surface-modified zirconium oxide particles was prepared, and the brightness was measured. That is, the white LED package of the reference example was produced in the same manner as in Example 1 except that, in the production of the LED package of Example 1, instead of setting the ratio between the total amount of the surface-modified zirconium oxide particles and the resin and the particles of a fluorescent body to 100:38, the ratio between the total amount of the resin and the particles of a fluorescent body was set to 100: 38.

As a result of carrying out measurement on the obtained white package in the same manner as in Example 1, the brightness of this white LED package was 72.5 lm.

As described above, in the dispersion liquids of Example 1 and Examples 2 in which the zirconium oxide particles were dispersed in a high concentration of a silane compound, even in a case where methyl phenyl silicone and the dispersion liquid were mixed together, the zirconium oxide particles were preferably dispersed, and the occurrence of turbidity or an excessive increase in the viscosity was not observed. In addition, it was confirmed that the brightness of the white LED package can be improved.

On the other hand, in the dispersion liquid of Comparative Example 1, when methyl phenyl silicone and the dispersion liquid were mixed, the obtained composition gelled and was unsuitable as a composition for sealing light-emitting elements.

Hitherto, the preferred embodiment of the present invention has been described in detail with reference to the accompanying drawings, but the present invention is not limited to such examples. It is evident that a person skilled in the art of the present invention is able to conceive a variety of modification examples or correction examples within the scope of the technical concept described in the claims, and it is needless to say that such examples are understood to be in the technical scope of the present invention.

Industrial Applicability

It is possible to provide a dispersion liquid in which metal oxide particles are contained and the agglomeration of the metal oxide particles is being suppressed when dispersed in a methyl-based silicone resin, a composition containing the same, a sealing member that is formed using the composition, a light-emitting device having the sealing member, an illumination tool and a display device each including the light-emitting device, and a method for producing a dispersion liquid.

Reference Signs List

1A, 1B, 1C, 1D Light-emitting device
2 Substrate
2a Substrate upper part
2b Substrate lower part
21 Recess portion
21a Bottom of recess portion
3 Light-emitting element
4A, 4B, 4C, 4D Sealing member
41B, 41C, 41D First layer
43B, 43C, 43D Second layer
45D Third layer
5 Particle of fluorescent body

**Claims**

1. A dispersion liquid comprising:

   a metal oxide particle which has been surface-modified by a surface-modifying material; and
   a hydrophobic solvent,
   wherein the surface-modifying material contains a silane compound and a silicone compound,
   when a transmission spectrum of the metal oxide particles that are obtained by drying the dispersion liquid by vacuum drying is measured in a wavenumber range of 800 cm$^{-1}$ or more and 3,800 cm$^{-1}$ or less with a Fourier transform infrared spectrophotometer, and spectrum values are standardized such that a maximum value of the spectrum in the range becomes 100 and a minimum value becomes 0, the following formula (1) is satisfied:

$$IA/IB \leq 3.5 \qquad (1)$$

(in the formula, "IA" represents a spectrum value at 3,500 cm$^{-1}$ and "IB" represents a spectrum value at 1,100 cm$^{-1}$), and

when the dispersion liquid and methyl phenyl silicone are mixed such that a mass ratio of a total mass of the metal oxide particles and the surface-modifying material to a mass of methyl phenyl silicone becomes 30:70, and then the hydrophobic solvent is removed, a viscosity is 9 Pa·s or less.

2. The dispersion liquid according to Claim 1,
   wherein the IA/IB is 2.0 or less.

3. The dispersion liquid according to Claim 1,

   wherein the metal oxide particles contain at least one of a zirconium oxide particle and a titanium oxide particle, and
   a content of the metal oxide particles in the dispersion liquid is 1% by mass or more and 70% by mass or less.

4. The dispersion liquid according to Claim 1,
   wherein an average primary particle diameter of the metal oxide particles is 3 nm or more and 200 nm or less.

5. The dispersion liquid according to Claim 1,
   wherein an average dispersed-particle diameter of the metal oxide particles is 10 nm or more and 300 nm or less.

6. The dispersion liquid according to Claim 1,

   wherein the hydrophobic solvent is at least one selected from the group consisting of benzene, toluene, ethylbenzene, 1-phenylpropane, isopropylbenzene, n-butylbenzene, tert-butylbenzene, sec-butylbenzene, o-, m-, or p-xylene, and 2-, 3-, or 4-ethyltoluene, and
   a content of the hydrophobic solvent is 40% by mass or more and 95% by mass or less with respect to an amount of the dispersion liquid.

7. The dispersion liquid according to Claim 1,

   wherein the silane compound is a silane compound having 1 or more and 3 or less alkyl groups having 1 or more and 5 or less carbon atoms and 1 or more and 3 or less alkoxy groups having 1 or more and 5 or less carbon atoms, and
   a content of the silane compound is 50% by mass or more and 500% by mass or less with respect to an amount of the metal oxide particles.

8. The dispersion liquid according to Claim 1,

   wherein the silicone compound contains at least one selected from the group consisting of methoxy group-containing phenyl silicone, dimethyl silicone, and methoxy group-containing dimethyl silicone, and
   a content of the silicone compound is 50% by mass or more and 500% by mass or less with respect to an amount of the metal oxide particles.

9. The dispersion liquid according to Claim 1,
   wherein a viscosity in a case of removing the hydrophobic solvent is 1 Pa·s or more.

10. A composition that is a mixture of the dispersion liquid according to Claim 1 and a resin component.

11. A sealing member that is a cured product of the composition according to Claim 10.

12. A light-emitting device comprising:

the sealing member according to Claim 11; and

a light-emitting element sealed with the sealing member.

13. An illumination tool comprising:

the light-emitting device according to Claim 12.

14. A display device comprising:

the light-emitting device according to Claim 12.

15. A method for producing a dispersion liquid, comprising:

a step B of mixing a silane compound and metal oxide particles to obtain a liquid mixture;

a step C of dispersing the metal oxide particles in the liquid mixture to obtain a first dispersion liquid in which the metal oxide particles are dispersed;

a step D of adding a hydrophobic solvent to the first dispersion liquid to obtain a second dispersion liquid; and

a step E of adding a silicone compound to the second dispersion liquid to obtain a third dispersion liquid,

wherein a content of the metal oxide particles in the liquid mixture of the step B is 10% by mass or more and 49% by mass or less,

a total content of the silane compound and the metal oxide particles in the liquid mixture of the step B is 65% by mass or more and 98% by mass or less, and

the step D of adding the hydrophobic solvent is any step selected from

a step d1 of heating the first dispersion liquid and, after heating, adding the hydrophobic solvent at a rate at which the metal oxide particles do not agglomerate,

a step d2 of adding the hydrophobic solvent at a rate at which the metal oxide particles do not agglomerate, while heating the first dispersion liquid, and

a step d3 of adding the hydrophobic solvent at a rate at which the metal oxide particles do not agglomerate and then heating the first dispersion liquid.

16. The method for producing a dispersion liquid according to Claim 15,

wherein, in the step B, a dispersion medium is further mixed, and

an amount of the dispersion medium in the liquid mixture is 2% by mass or more and 35% by mass or less.

17. The method for producing a dispersion liquid according to Claim 15,

wherein, in the step B, an amount of an unavoidable alcohol compound generated by hydrolysis is 2% by mass or more and 35% by mass or less.

18. The method for producing a dispersion liquid according to Claim 15, further comprising, before the step B:

a step A of mixing a silane compound and water to prepare a hydrolyzed liquid containing a hydrolyzed silane compound,

wherein, in the step B, the hydrolyzed liquid containing the silane compound is mixed with the metal oxide particles.

19. The method for producing a dispersion liquid according to Claim 18,

wherein the hydrolyzed liquid further contains at least one of a catalyst and a hydrophilic solvent.

20. The method for producing a dispersion liquid according to Claim 15,

wherein the metal oxide particles contain at least one of a zirconium oxide particle and a titanium oxide particle,

a content of the metal oxide particles in the third dispersion liquid is 1% by mass or more and 70% by mass or less,

an average primary particle diameter of the metal oxide particles is 3 nm or more and 200 nm or less,

an average dispersed-particle diameter of the metal oxide particles in the third dispersion liquid is 10 nm or more and 300 nm or less,

the hydrophobic solvent is at least one selected from the group consisting of benzene, toluene, ethylbenzene, 1-phenylpropane, isopropylbenzene, n-butylbenzene, tert-butylbenzene, sec-butylbenzene, o-, m-, or p-xylene, and 2-, 3-, or 4-ethyltoluene, and

a content of the hydrophobic solvent is 40% by mass or more and 95% by mass or less with respect to an amount of the dispersion liquid.

21. The method for producing a dispersion liquid according to Claim 15,
    wherein the silane compound is a silane compound having 1 or more and 3 or less alkyl groups having 1 or more and 5 or less carbon atoms and 1 or more and 3 or less alkoxy groups having 1 or more and 5 or less carbon atoms,

    a content of the silane compound is 50% by mass or more and 500% by mass or less with respect to an amount of the metal oxide particles,
    the silicone compound contains at least one selected from the group consisting of methoxy group-containing phenyl silicone, dimethyl silicone, and methoxy group-containing dimethyl silicone, and
    a content of the silicone compound is 50% by mass or more and 500% by mass or less with respect to the amount of the metal oxide particles.

# FIG. 1

# FIG. 2

## FIG. 3

## FIG. 4

| | INTERNATIONAL SEARCH REPORT | International application No. |
|---|---|---|
| | | PCT/JP2021/012271 |

**A. CLASSIFICATION OF SUBJECT MATTER**
Int.Cl. C01G25/02(2006.01)i, H01L23/29(2006.01)i, H01L23/31(2006.01)i,
C08K9/06(2006.01)i, C08L101/00(2006.01)i, H01L33/56(2010.01)i
FI: C01G25/02, C08K9/06, C08L101/00, H01L23/30F, H01L33/56
According to International Patent Classification (IPC) or to both national classification and IPC

**B. FIELDS SEARCHED**

Minimum documentation searched (classification system followed by classification symbols)
Int.Cl. C01G25/02, H01L23/29, H01L23/31, C08K9/06, C08L101/00, H01L33/56

Documentation searched other than minimum documentation to the extent that such documents are included in the fields searched
   Published examined utility model applications of Japan    1922-1996
   Published unexamined utility model applications of Japan  1971-2021
   Registered utility model specifications of Japan      1996-2021
   Published registered utility model applications of Japan   1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2018-107472 A (SUMITOMO OSAKA CEMENT CO., LTD.) 05 July 2018 (2018-07-05), entire text | 1-21 |
| A | JP 2016-175804 A (SUMITOMO OSAKA CEMENT CO., LTD.) 06 October 2016 (2016-10-06), entire text | 1-21 |
| A | JP 2009-149454 A (KANEKA CORPORATION) 09 July 2009 (2009-07-09), entire text | 1-21 |
| A | JP 2008-120605 A (SUMITOMO OSAKA CEMENT CO., LTD.) 29 May 2008 (2008-05-29), entire text | 1-21 |
| P, A | WO 2020/203462 A1 (SUMITOMO OSAKA CEMENT CO., LTD.) 08 October 2020 (2020-10-08), entire text | 1-21 |

☐ Further documents are listed in the continuation of Box C.   ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 May 2021 | 18 May 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT
Information on patent family members

International application No.

PCT/JP2021/012271

| JP 2018-107472 A | 05 July 2018 | (Family: none) |
| JP 2016-175804 A | 06 October 2016 | (Family: none) |
| JP 2009-149454 A | 09 July 2009 | (Family: none) |
| JP 2008-120605 A | 29 May 2008 | (Family: none) |
| WO 2020/203462 A1 | 08 October 2020 | (Family: none) |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020056492 A

- WO 2016142992 A